(19) Europäisches Patentamt
European Patent Office
Office européen des brevets

(11) **EP 3 606 044 A1**

(12) **EUROPEAN PATENT APPLICATION**
published in accordance with Art. 153(4) EPC

(43) Date of publication:
**05.02.2020 Bulletin 2020/06**

(51) Int Cl.:
*H04N 5/369* (2011.01)    *G02B 7/34* (2006.01)
*G03B 13/36* (2006.01)    *H04N 5/232* (2006.01)

(21) Application number: **18777861.8**

(22) Date of filing: **28.03.2018**

(86) International application number:
**PCT/JP2018/012996**

(87) International publication number:
**WO 2018/181591 (04.10.2018 Gazette 2018/40)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **28.03.2017 JP 2017063678**

(71) Applicant: **Nikon Corporation**
**Tokyo 108-6290 (JP)**

(72) Inventors:
• **NAKAYAMA, Satoshi**
**Tokyo 108-6290 (JP)**
• **TAKAGI, Toru**
**Tokyo 108-6290 (JP)**
• **SEO, Takashi**
**Tokyo 108-6290 (JP)**
• **ANDO, Ryoji**
**Tokyo 108-6290 (JP)**
• **KATO, Shutaro**
**Tokyo 108-6290 (JP)**

(74) Representative: **Hoffmann Eitle**
**Patent- und Rechtsanwälte PartmbB**
**Arabellastraße 30**
**81925 München (DE)**

(54) **IMAGING ELEMENT AND IMAGING DEVICE**

(57)    An image sensor includes: a photoelectric conversion unit that photoelectrically converts incident light and generates electric charge; a reflecting portion that reflects a portion of light passing through the photoelectric conversion unit toward the photoelectric conversion unit; a first output unit that outputs electric charge generated due to photoelectric conversion by the photoelectric conversion unit of light reflected by the reflecting portion; and a second output unit that outputs electric charge generated due to photoelectric conversion by the photoelectric conversion unit of light other than the light reflected by the reflecting portion.

FIG. 6

(b)

EP 3 606 044 A1

**Description**

TECHNICAL FIELD

The present invention relates to an image sensor and to an imaging device.

BACKGROUND ART

An image sensor is per se known (refer to PTL 1) in which a reflecting layer is provided underneath a photoelectric conversion unit, and in which light that has passed through the photoelectric conversion unit is reflected back to the photoelectric conversion unit by this reflecting layer. With a prior art image sensor, output of electric charge generated by photoelectric conversion of incident light and output of electric charge generated by photoelectric conversion of light that is reflected back by such a reflecting layer are outputted by a single output unit.

CITATION LIST

PATENT LITERATURE

PTL 1: Japanese Laid-Open Patent Publication No. 2016-127043.

SUMMARY OF INVENTION

According to the 1st aspect of the present invention, an image sensor comprises: a photoelectric conversion unit that photoelectrically converts incident light and generates electric charge; a reflecting portion that reflects a portion of light passing through the photoelectric conversion unit toward the photoelectric conversion unit; a first output unit that outputs electric charge generated due to photoelectric conversion by the photoelectric conversion unit of light reflected by the reflecting portion; and a second output unit that outputs electric charge generated due to photoelectric conversion by the photoelectric conversion unit of light other than the light reflected by the reflecting portion.

According to the 2nd aspect of the present invention, an imaging device comprises: an image sensor according to the 1st aspect; and a control unit that controls a position of a focusing lens of an optical system so as to focus an image due to the optical system upon the image sensor, based upon a signal based upon electric charge outputted from the first output unit of the image sensor that captures an image due to the optical system.

According to the 3rd aspect of the present invention, an imaging device comprises: an image sensor according to the following; and a control unit that controls a position of a focusing lens of an optical system so as to focus an image due to the optical system upon the image sensor, based upon a signal based upon electric charge outputted from the first output unit of the first pixel and electric charge outputted from the first output unit of the second pixel of the image sensor that captures an image due to the optical system. The image sensor accords to the 1st aspect, and further comprises: a first pixel and a second pixel each of which comprises the photoelectric conversion unit and the reflecting portion, wherein: the first pixel and the second pixel are arranged along a first direction; in a plane that intersects a direction in which light is incident, the reflecting portion of the first pixel is provided in at least a part of a region that is more toward a direction opposite to the first direction than a center of the photoelectric conversion unit; and in a plane that intersects the direction in which light is incident, the reflecting portion of the second pixel is provided in at least a part of a region that is more toward the first direction than the center of the photoelectric conversion unit.

BRIEF DESCRIPTION OF DRAWINGS

[Fig. 1] Fig. 1 is a figure showing the structure of principal portions of a camera;
[Fig. 2] Fig. 2 is a figure showing an example of focusing areas;
[Fig. 3] Fig. 3 is an enlarged figure showing a portion of an array of pixels upon an image sensor;
[Fig. 4] Fig. 4(a) is an enlarged sectional view of an example of an imaging pixel, and Figs. 4(b) and 4(c) are enlarged sectional views of examples of focus detection pixels;
[Fig. 5] Fig. 5 is a figure for explanation of ray bundles incident upon focus detection pixels; [Fig. 6] Fig. 6 is an enlarged sectional view of focus detection pixels and an imaging pixel according to a first embodiment;
[Fig. 7] Fig. 7(a) and Fig. 7(b) are enlarged sectional views of focus detection pixels;
[Fig. 8] Fig. 8 is a plan view schematically showing an arrangement of focus detection pixels and imaging pixels;
[Fig. 9] Fig. 9(a) and Fig. 9(b) are enlarged sectional views of focus detection pixels according to a first variant embodiment;

[Fig. 10]Fig. 10 is a plan view schematically showing an arrangement of focus detection pixels and imaging pixels according to a first variant embodiment;

[Fig. 11]Fig. 11(a) and Fig. 11(b) are enlarged sectional views of focus detection pixels according to a second variant embodiment;

[Fig. 12]Fig. 12(a) and Fig. 12(b) are enlarged sectional views of focus detection pixels according to a third variant embodiment;

[Fig. 13]Fig. 13 is a plan view schematically showing an arrangement of focus detection pixels and imaging pixels according to the third variant embodiment; and

[Fig. 14]Fig. 14(a) is a figure showing examples of an "a" group signal and a "b" group signal, and Fig. 14(b) is a figure showing an example of a signal obtained by averaging this "a" group signal and this "b" group signal.

DESCRIPTION OF EMBODIMENTS

Embodiment One

An image sensor (an imaging element), a focus detection device, and an imaging device (an image-capturing device) according to an embodiment will now be explained with reference to the drawings. An interchangeable lens type digital camera (hereinafter termed the "camera 1") will be shown and described as an example of an electronic device to which the image sensor according to this embodiment is mounted, but it would also be acceptable for the device to be an integrated lens type camera in which the interchangeable lens 3 and the camera body 2 are integrated together.

Moreover, the electronic device is not limited to being a camera 1; it could also be a smart phone, a wearable terminal, a tablet terminal or the like that is equipped with an image sensor.

Structure of the Principal Portions of the Camera

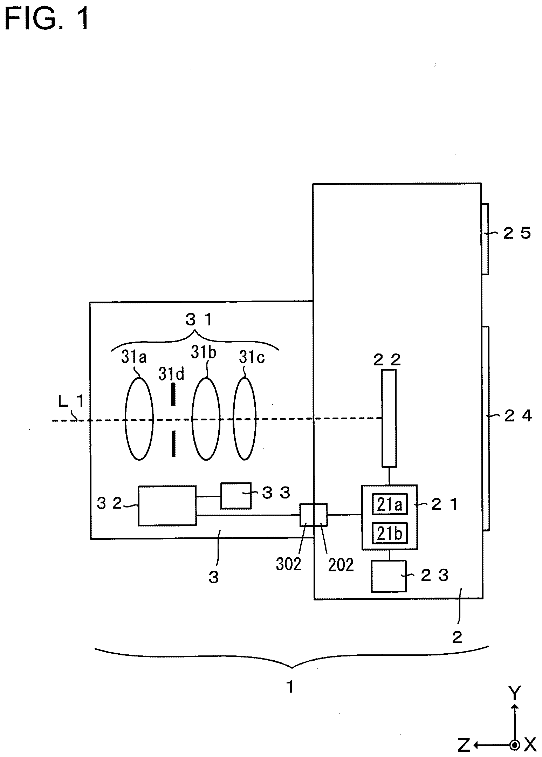

Fig. 1 is a figure showing the structure of principal portions of the camera 1. The camera 1 comprises a camera body 2 and an interchangeable lens 3. The interchangeable lens 3 is installed to the camera body 2 via a mounting portion not shown in the figures. When the interchangeable lens 3 is installed to the camera body 2, a connection portion 202 on the camera body 2 side and a connection portion 302 on the interchangeable lens 3 side are connected together, and communication between the camera body 2 and the interchangeable lens 3 becomes possible.

Referring to Fig. 1, light from the photographic subject is incident in the -Z axis direction in Fig. 1. Moreover, as shown by the coordinate axes, the direction orthogonal to the Z axis and outward from the drawing paper will be taken as being the +X axis direction, and the direction orthogonal to the Z axis and to the X axis and in the upward direction will be taken as being the +Y axis direction. In the various subsequent figures, coordinate axes that are referred to the coordinate axes of Fig. 1 will be shown, so that the orientations of the various figures can be understood.

The Interchangeable Lens

The interchangeable lens 3 comprises an imaging optical system (i.e. an image formation optical system) 31, a lens control unit 32, and a lens memory 33. The imaging optical system 31 may include, for example, a plurality of lenses 31a, 31b and 31c that include a focus adjustment lens (i.e. a focusing lens) 31c, and an aperture 31d, and forms an image of the photographic subject upon an image formation surface of an image sensor 22 that is provided to the camera body 2.

On the basis of signals outputted from a body control unit 21 of the camera body 2, the lens control unit 32 adjusts the position of the focal point of the imaging optical system 31 by shifting the focus adjustment lens 31c forwards and backwards along the direction of the optical axis L1. The signals outputted from the body control unit 21 during focus adjustment include information specifying the shifting direction of the focus adjustment lens 31c and its shifting amount, its shifting speed, and so on.

Moreover, the lens control unit 32 controls the aperture diameter of the aperture 31d on the basis of a signal outputted from the body control unit 21 of the camera body 2.

The lens memory 33 is, for example, built by a non-volatile storage medium and so on. Information relating to the interchangeable lens 3 is recorded in the lens memory 33 as lens information. For example, information related to the position of the exit pupil of the imaging optical system 31 is included in this lens information. The lens control unit 32 performs recording of information into the lens memory 33 and reading out of lens information from the lens memory 33.

The Camera Body

The camera body 2 comprises the body control unit 21, the image sensor 22, a memory 23, a display unit 24, and a actuation unit 25. The body control unit 21 is built by a CPU, ROM, RAM and so on, and controls the various sections of the camera 1 on the basis of a control program.

The image sensor 22 is built by a CCD image sensor or a CMOS image sensor. The image sensor 22 receives a ray bundle (a light flux) that has passed through the exit pupil of the imaging optical system 31 upon its image formation surface, and an image of the photographic subject is photoelectrically converted (image capture). In this photoelectric conversion process, each of a plurality of pixels that are disposed at the image formation surface of the image sensor 22 generates an electric charge that corresponds to the amount of light that it receives. And signals due to the electric charges that are thus generated are read out from the image sensor 22 and sent to the body control unit 21.

It should be understood that both image signals and signals for focus detection are included in the signals generated by the image sensor 22. The details of these image signals and of these focus detection signals will be described hereinafter.

The memory 23 is, for example, built by a recording medium such as a memory card or the like. Image data and audio data and so on are recorded in the memory 23. The recording of data into the memory 23 and the reading out of data from the memory 23 are performed by the body control unit 21. According to commands from the body control unit 21, the display unit 24 displays an image based upon the image data and information related to photography such as the shutter speed, the aperture value and so on, and also displays a menu actuation screen or the like. The actuation unit 25 includes a release button, a video record button, setting switches of various types and so on, and outputs actuation signals respectively corresponding to these actuations to the body control unit 21.

Moreover, the body control unit 21 described above includes a focus detection unit 21a and an image generation unit 21b. The focus detection unit 21a detects the focusing position of the focus adjustment lens 31c for focusing an image formed by the imaging optical system 31 upon the image formation surface of the image sensor 22. The focus detection unit 21a performs focus detection processing required for automatic focus adjustment (AF) of the imaging optical system 31. A simple explanation of the flow of focus detection processing will now be given. First, on the basis of the focus detection signals read out from the image sensor 22, the focus detection unit 21a calculates the amount of defocusing by a pupil-split type phase difference detection method. In concrete terms, an amount of image deviation of images due to a plurality of ray bundles that have passed through different regions of the pupil of the imaging optical system 31 is detected, and the amount of defocusing is calculated on the basis of the amount of image deviation that has thus been detected. Then the focus detection unit 21a calculates a shifting amount for the focus adjustment lens 31c to its focused position on the basis of this amount of defocusing that has thus been calculated.

And the focus detection unit 21a makes a decision as to whether or not the amount of defocusing is within a permitted value. If the focus detection unit 21a determines that the amount of defocusing is within the permitted value, then the focus detection unit 21a determines that the system is adequately focused, and the focus detection process terminates. On the other hand, if the amount of defocusing is greater than the permitted value, then the focus detection unit 21 determines that the system is not adequately focused, and sends the calculated shifting amount for shifting the focus adjustment lens 31c and a lens shift command to the lens control unit 32 of the interchangeable lens 3, and then the focus detection process terminates. And, upon receipt of this command from the focus detection unit 21a, the lens control unit 32 performs focus adjustment automatically by causing the focus adjustment lens 31c to shift according to the calculated shifting amount.

On the other hand, the image generation unit 21b of the body control unit 21 generates image data related to the image of the photographic subject on the basis of the image signals read out from the image sensor 22. Moreover, the image generation unit 21b performs predetermined image processing upon the image data that it has thus generated. This image processing may, for example, include per se known image processing such as tone conversion processing, color interpolation processing, contour enhancement processing, and so on.

Explanation of the Image sensor

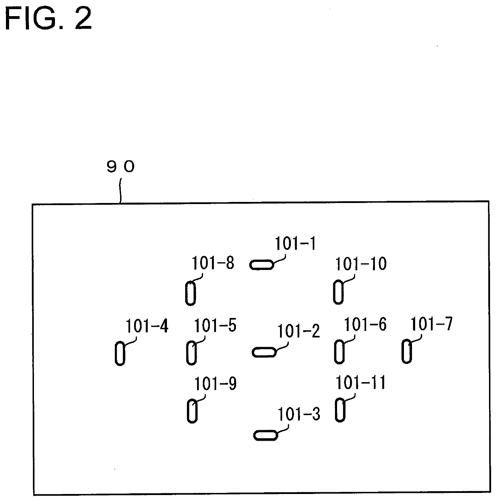

Fig. 2 is a figure showing an example of focusing areas defined in a photographic scene 90. These focusing areas are areas for which the focus detection unit 21a detects amounts of image deviation described above as phase difference information, and they may also be termed "focus detection areas", "range-finding points", or "auto focus (AF) points". In this embodiment, eleven focusing areas 101-1 through 110-11 are provided in advance within the photographic scene 90, and the camera is capable of detecting the amounts of image deviation in these eleven areas. It should be understood that this number of focusing areas 101-1 through 101-11 is only an example; there could be more than eleven such areas, or fewer. It would also be acceptable to set the focusing areas 101-1 through 101-11 over the entire photographic scene 90.

The focusing areas 101-1 through 101-11 correspond to the positions at which focus detection pixels 11, 13 are disposed, as will be described hereinafter.

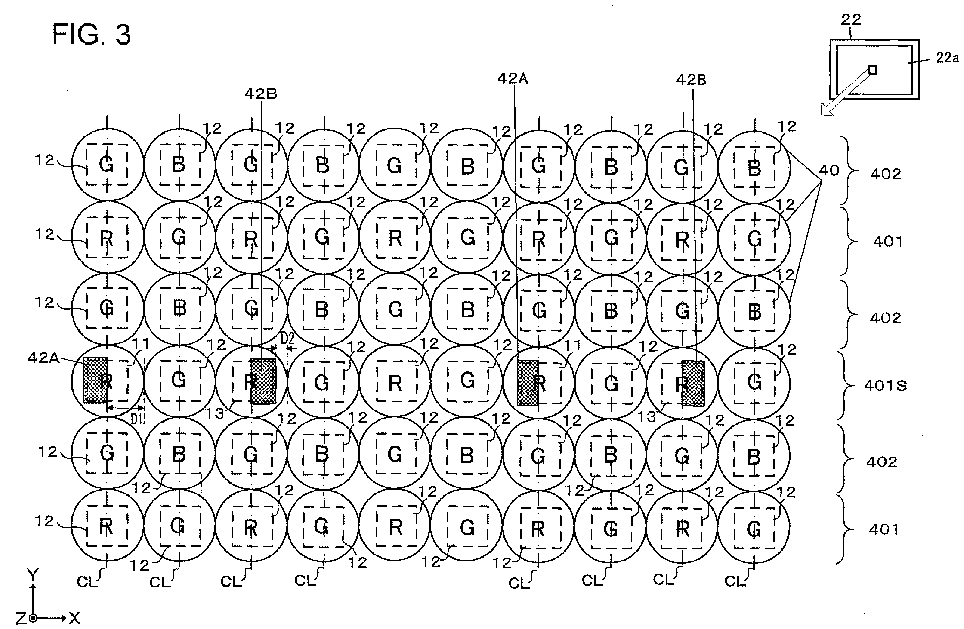

Fig. 3 is an enlarged view of a portion of an array of pixels on the image sensor 22. A plurality of pixels that include photoelectric conversion units are arranged upon the image sensor 22 in a two dimensional configuration (for example, in a row direction and a column direction) within a region 22a that generates an image. To each of the pixels is provided one of three color filters having different spectral characteristics, for example R (red), G (green), and B (blue). The R color filters principally pass light in a red color wavelength region. Moreover, the G color filters principally pass light in a green color wavelength region. And the B color filters principally pass light in a blue color wavelength region. Due to this, the various pixels have different spectral characteristics, according to the color filters with which they are provided. The G color filters pass light of a shorter wavelength region than the R color filters. And the B color filters pass light of a shorter wavelength region than the G color filters.

On the image sensor 22, pixel rows 401 in which pixels having R and G color filters (hereinafter respectively termed "R pixels" and "G pixels") are arranged alternately, and pixel rows 402 in which pixels having G and B color filters (hereinafter respectively termed "G pixels" and "B pixels") are arranged alternately, are arranged repeatedly in a two dimensional pattern. In this manner, for example, the R pixels, G pixels, and B pixels are arranged according to a Bayer array.

The image sensor 22 includes imaging pixels 12 that are R pixels, G pixels, and B pixels arrayed as described above, and focus detection pixels 11, 13 that are disposed so as to replace some of the imaging pixels 12. Among the pixel rows 401, the reference symbol 401S is appended to the pixel rows in which focus detection pixels 11, 13 are disposed.

In Fig. 3, a case is shown by way of example in which the focus detection pixels 11, 13 are arranged along the row direction (the X axis direction), in other words along the horizontal direction. A plurality of pairs of the focus detection pixels 11, 13 are arranged repeatedly along the row direction (the X axis direction). In this embodiment, each of the focus detection pixels 11, 13 is disposed in the position of an R pixel. The focus detection pixels 11 have reflecting portions 42A, and the focus detection pixels 13 have reflecting portions 42B.

It would also be acceptable to arrange for a plurality of the pixel rows 401S shown by way of example in Fig. 3 to be disposed repeatedly along the column direction (i.e. along the Y axis direction).

It should be understood that it would be acceptable for the focus detection pixels 11, 13 to be disposed in the positions of some of R pixels; or it would also be acceptable for the focus detection pixels 11, 13 to be disposed in the positions of all R pixels. It would also be acceptable for each of the focus detection pixels 11, 13 to be disposed in the position of a G pixel.

The signals that are read out from the imaging pixels 12 of the image sensor 22 are employed as image signals by the body control unit 21. Moreover, the signals that are read out from the focus detection pixels 11, 13 of the image sensor 22 are employed as focus detection signals by the body control unit 21.

It should be understood that the signals that are read out from the focus detection pixels 11, 13 of the image sensor 22 may be also employed as image signals by being corrected.

Next, the imaging pixels 12 and the focus detection pixels 11, 13 will be explained in detail.

The Imaging Pixels

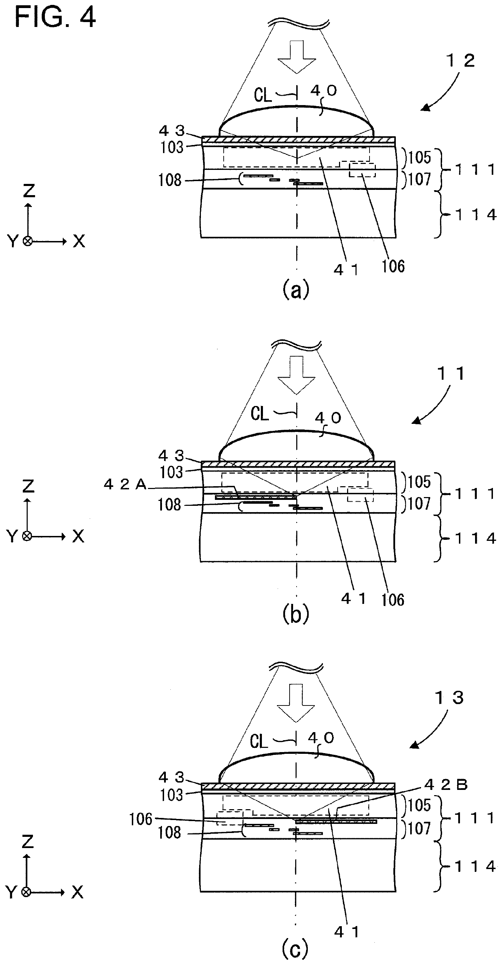

Fig. 4(a) is an enlarged sectional view of an exemplary one of the imaging pixels 12, and is a sectional view of one of the imaging pixels 12 of Fig. 3 taken in a plane parallel to the X-Z plane. The line CL is a line passing through the center of this imaging pixel 12. This image sensor 22 is, for example, of the backside illumination type, with a first substrate 111 and a second substrate 114 being laminated together therein via an adhesion layer not shown in the figures. The first substrate 111 is made as a semiconductor substrate. Moreover, the second substrate 114 is made as a semiconductor substrate or as a glass substrate or the like, and functions as a support substrate for the first substrate 111.

A color filter 43 is provided over the first substrate 111 (on its side in the +Z axis direction) via a reflection prevention layer 103. Moreover, a micro lens 40 is provided over the color filter 43 (on its side in the +Z axis direction). Light is incident upon the imaging pixel 12 in the direction shown by the white arrow sign from above the micro lens 40 (i.e. from the +Z axis direction). The micro lens 40 condenses the incident light onto a photoelectric conversion unit 41 on the first substrate 111.

In relation to the micro lens 40 of this imaging pixel 12, the optical characteristics of the micro lens 40, for example its optical power, are determined so as to cause the intermediate position in the thickness direction (i.e. in the Z axis direction) of the photoelectric conversion unit 41 and the position of the pupil of the imaging optical system 31 (i.e. an exit pupil 60 that will be explained hereinafter) to be mutually conjugate. The optical power may be adjusted by varying the curvature of the micro lens 40 or by varying its refractive index. Varying the optical power of the micro lens 40 means changing the focal length of the micro lens 40. Moreover, it would also be acceptable to arrange to adjust the focal length of the micro lens 40 by changing its shape or its material. For example, if the curvature of the micro lens 40 is reduced, then its focal length becomes longer. Moreover, if the curvature of the micro lens 40 is increased, then its focal length becomes shorter. If the micro lens 40 is made from a material whose refractive index is low, then its focal length becomes longer. Moreover, if the micro lens 40 is made from a material whose refractive index is high, then its focal length becomes shorter. If the thickness of the micro lens 40 (i.e. its dimension in the Z axis direction) becomes smaller, then its focal length becomes longer. Moreover, if the thickness of the micro lens 40 (i.e. its dimension in the Z axis direction) becomes larger, then its focal length becomes shorter. It should be understood that, when the focal length of the micro lens 40 becomes longer, then the position at which the light incident upon the photoelectric conversion unit 41 is condensed shifts in the direction to become deeper (i.e. shifts in the -Z axis direction). Moreover, when the focal length of the micro lens 40 becomes shorter, then the position at which the light incident upon the photoelectric conversion unit 41 is condensed shifts in the direction to become shallower (i.e. shifts in the +Z axis direction).

According to the structure described above, it is avoided that any part of the ray bundle that has passed through the pupil of the imaging optical system 31 is incident upon any region outside the photoelectric conversion unit 41, and leakage of the ray bundle to adjacent pixels is prevented, so that the amount of light incident upon the photoelectric conversion unit 41 is increased. To put it in another manner, the amount of electric charge generated by the photoelectric conversion unit 41 is increased.

A semiconductor layer 105 and a wiring layer 107 are laminated together in the first substrate 111. The photoelectric conversion unit 41 and an output unit 106 are provided in the first substrate 111. The photoelectric conversion unit 41 is built, for example, by a photodiode (PD), and light incident upon the photoelectric conversion unit 41 is photoelectrically converted and thereby electric charge is generated. Light that has been condensed by the micro lens 40 is incident upon the upper surface of the photoelectric conversion unit 41 (i.e. from the +Z axis direction). The output unit 106 includes a transfer transistor and an amplification transistor and so on, not shown in the figures. The output unit 106 outputs a signal on the basis of the electric charge generated by the photoelectric conversion unit 41 to the wiring layer 107. In the output unit 106, for example, n+ regions are formed on the semiconductor layer 105, and respectively constitute a source region and a drain region for the transfer transistor. Moreover, a gate electrode of the transfer transistor is formed on the wiring layer 107, and this electrode is connected to wiring 108 that will be described hereinafter.

The wiring layer 107 includes a conductor layer (i.e. a metallic layer) and an insulation layer, and a plurality of wires 108 and vias and contacts and so on not shown in the figure are disposed therein. For example, copper or aluminum or the like may be employed for the conductor layer. And the insulation layer may, for example, consist of an oxide layer or a nitride layer or the like. The signal of the imaging pixel 22 that has been outputted from the output unit 106 to the wiring layer 107 is, for example, subjected to signal processing such as A/D conversion and so on by peripheral circuitry not shown in the figures provided on the second substrate 114, and is read out by the body control unit 21 (refer to Fig. 1).

As shown by way of example in Fig. 3, a plurality of the imaging pixels 12 of Fig. 4(a) are arranged in the X axis direction and the Y axis direction, and these are R pixels, G pixels, and B pixels. These R pixels, G pixels, and B pixels all have the structure shown in Fig. 4(a), but with the spectral characteristics of their respective color filters 43 being different from one another.

The Focus Detection Pixels

Fig. 4(b) is an enlarged sectional view of an exemplary one of the focus detection pixels 11, and this sectional view of one of the focus detection pixels 11 of Fig. 3 is taken in a plane parallel to the X-Z plane. To structures that are similar to structures of the imaging pixel 12 of Fig. 4(a), the same reference symbols are appended, and explanation thereof will be curtailed. The line CL is a line passing through the center of this focus detection pixel 11, in other words extending along the optical axis of the micro lens 40 and through the center of the photoelectric conversion unit 41. The fact that this focus detection pixel 11 is provided with a reflecting portion 42A below the lower surface of its photoelectric conversion unit 41 (i.e. in the -Z axis direction) is a feature that is different, as compared with the imaging pixel 12 of Fig. 4(a). It should be understood that it would also be acceptable for this reflecting portion 42A to be provided as separated in the -Z axis direction from the lower surface of the photoelectric conversion unit 41. The lower surface of the photoelectric conversion unit 41 is its surface on the opposite side from its upper surface onto which the light is incident via the micro lens 40.

The reflecting portion 42A may, for example, be built as a multi-layered structure including a conductor layer made from copper, aluminum, tungsten or the like provided in the wiring layer 107, or an insulation layer made from silicon nitride or silicon oxide or the like. The reflecting portion 42A covers almost half of the lower surface of the photoelectric conversion unit 41 (on the left side of the line CL, i.e. the -X axis direction). Due to the provision of the reflecting portion 42A, at the left half of the photoelectric conversion unit 41, light that has been proceeding in the downward direction (i.e. in the -Z axis direction) in the photoelectric conversion unit 41 and has passed through the photoelectric conversion unit 41 is reflected back upward by the reflecting portion 42A, and is then again incident upon the photoelectric conversion unit 41 for a second time. Since this light that is again incident upon the photoelectric conversion unit 41 is photoelectrically converted thereby, accordingly the amount of electric charge that is generated by the photoelectric conversion unit 41 is increased, as compared to the case of an imaging pixel 12 to which no reflecting portion 42A is provided.

In relation to the micro lens 40 of this focus detection pixel 11, the optical power of the micro lens 40 is determined so that the position of the lower surface of the photoelectric conversion unit 41, in other words the position of the reflecting portion 42A, is conjugate to the position of the pupil of the imaging optical system 31 (in other words, to the exit pupil 60 that will be explained hereinafter).

Accordingly, as will be explained in detail hereinafter, along with first and second ray bundles that have passed through first and second regions of the pupil of the imaging optical system 31 being incident upon the photoelectric conversion unit 41, also, among the light that has passed through the photoelectric conversion unit 41, this second ray bundle that has passed through the second pupil region is reflected by the reflecting portion 42A, and is again incident upon the photoelectric conversion unit 41 for a second time.

Due to the provision of the structure described above, it is avoided that the first and second ray bundles should be incident upon a region outside the photoelectric conversion unit 41 or should leak to an adjacent pixel, so that the amount of light incident upon the photoelectric conversion unit 41 is increased. To put this in another manner, the amount of electric charge generated by the photoelectric conversion unit 41 is increased.

It should be understood that it would also be acceptable for a part of the wiring 108 formed in the wiring layer 107, for example a part of a signal line connected to the output unit 106, to be also employed as the reflecting portion 42A. In this case, the reflecting portion 42A would serve both as a reflective layer that reflects back light that has been proceeding in the direction downward (i.e. in the -Z axis direction) in the photoelectric conversion unit 41 and has passed through the photoelectric conversion unit 41, and also as a signal line that transmits a signal.

In a similar manner to the case with the imaging pixel 12, the signal of the focus detection pixel 11 that has been outputted from the output unit 106 to the wiring layer 107 is subjected to signal processing such as, for example, A/D conversion and so on by peripheral circuitry not shown in the figures provided on the second substrate 114, and is then read out by the body control unit 21 (refer to Fig. 1).

It should be understood that, in Fig. 4(b), it is shown that the output unit 106 of the focus detection pixel 11 is provided at a region of the focus detection pixel 11 at which the reflecting portion 42A is not present (i.e. at a region more toward the +X axis direction than the line CL). However, it would also be acceptable for the output unit 106 to be provided at a region of the focus detection pixel 11 at which the reflecting portion 42A is present (i.e. at a region more toward the -X axis direction than the line CL).

Fig. 4(c) is an enlarged sectional view of an exemplary one of the focus detection pixels 13, and is a sectional view of one of the focus detection pixels 13 of Fig. 3 taken in a plane parallel to the X-Z plane. To structures that are similar to structures of the focus detection pixel 11 of Fig. 4(b), the same reference symbols are appended, and explanation thereof will be curtailed. This focus detection pixel 13 has a reflecting portion 42B in a position that is different from that of the reflecting portion 42A of the focus detection pixel 11 of Fig. 4(b). The reflecting portion 42B covers almost half of the lower surface of the photoelectric conversion unit 41 (the portion more to the right side (i.e. toward the +X axis direction) than the line CL). Due to the provision of this reflecting portion 42B, on the right half of the photoelectric conversion unit 41, light that has been proceeding in the downward direction (i.e. in the -Z axis direction) in the photoelectric conversion unit 41 and has passed through the photoelectric conversion unit 41 is reflected back by the reflecting portion 42B, and is then again incident upon the photoelectric conversion unit 41. Since this light that is again incident upon the photoelectric conversion unit 41 is photoelectrically converted thereby, accordingly the amount of electric charge that is generated by the photoelectric conversion unit 41 is increased, as compared with the case of an imaging pixel 12 to which no reflecting portion 42B is provided.

In other words, as will be explained hereinafter in detail, in the focus detection pixel 13, along with first and second ray bundles that have passed through the first and second regions of the pupil of the imaging optical system 31 being incident upon the photoelectric conversion unit 41, among the light that passes through the photoelectric conversion unit 41, the first ray bundle that has passed through the first pupil region is reflected back by the reflecting portion 42B and is again incident upon the photoelectric conversion unit 41 for a second time.

As described above, in the focus detection pixels 11, 13, among the first and second ray bundles that have passed through the first and second regions of the pupil of the imaging optical system 31, for example, the reflecting portion 42B of the focus detection pixel 13 reflects back the first ray bundle, while, for example, the reflecting portion 42A of the focus detection pixel 11 reflects back the second ray bundle.

In the focus detection pixel 13, in relation to the micro lens 40, the optical power of the micro lens 40 is determined so that the position of the reflecting portion 42B that is provided at the lower surface of the photoelectric conversion unit 41 and the position of the pupil of the imaging optical system 31 (i.e. the position of its exit pupil 60 that will be explained hereinafter) are mutually conjugate.

By providing the structure described above, the first and second ray bundles are prevented from being incident upon regions other than the photoelectric conversion unit 41, and leakage to adjacent pixels is prevented, so that the amount of light incident upon the photoelectric conversion unit 41 is increased. To put it in another manner, the amount of electric charge generated by the photoelectric conversion unit 41 is increased.

In the focus detection pixel 13, it would also be possible to employ a part of the wiring 108 formed on the wiring layer 107, for example a part of a signal line that is connected to the output unit 106, as the reflecting portion 42B, in a similar manner to the case with the focus detection pixel 11. In this case, the reflecting portion 42B would be employed both as a reflecting layer that reflects back light that has been proceeding in a downward direction (i.e. in the -Z axis direction) in the photoelectric conversion unit 41 and has passed through the photoelectric conversion unit 41, and also as a signal line for transmitting a signal.

Moreover, in the focus detection pixel 13, it would also be acceptable to employ, as the reflecting portion 42B, a part of an insulation layer that is employed in the output unit 106. In this case, the reflecting portion 42B would be employed both as a reflecting layer that reflects back light that has been proceeding in a downward direction (i.e. in the -Z axis direction) in the photoelectric conversion unit 41 and has passed through the photoelectric conversion unit 41, and also as an insulation layer.

In a similar manner to the case with the focus detection pixel 11, the signal of the focus detection pixel 13 that is outputted from the output unit 106 to the wiring layer 107 is subjected to signal processing such as A/D conversion and so on by, for example, peripheral circuitry not shown in the figures provided to the second substrate 114, and is read out by the body control unit 21 (refer to Fig. 1).

It should be understood that, in a similar manner to the case with the focus detection pixel 11, the output unit 106 of the focus detection pixel 13 may be provided in a region in which the reflecting portion 42B is not present (i.e. in a region more to the -X axis direction than the line CL), or may be provided in a region in which the reflecting portion 42B is present (i.e. in a region more to the +X axis direction than the line CL).

In general, semiconductor substrates such as silicon substrates or the like have the characteristic that their transmittance is different according to the wavelength of the incident light. With light of longer wavelength, the transmittance through a silicon substrate is higher as compared to light of shorter wavelength. For example, among the light that is photoelectrically converted by the image sensor 22, the light of red color whose wavelength is longer passes more easily through the semiconductor layer 105 (i.e. through the photoelectric conversion unit 41), as compared to the light of other colors (i.e. of green color or blue color).

In the example of Fig. 3, the focus detection pixels 11, 13 are disposed in the positions of R pixels. Due to this, if the light proceeding in the downward direction through the photoelectric conversion units 41 (i.e. in the -Z axis direction) is red color light, then it can easily pass through the photoelectric conversion units 41 and reach the reflecting portions 42A, 42B. And, due to this, this light of red color that has passed through the photoelectric conversion units 41 can be reflected back by the reflecting portions 42A, 42B so as to be again incident upon the photoelectric conversion units 41 for a second time. As a result, the amounts of electric charge generated by the photoelectric conversion units 41 of the focus detection pixels 11, 13 are increased.

As described above, the position of the reflecting portion 42A of the focus detection pixel 11 and the position of the reflecting portion 42B of the focus detection pixel 13, with respect to the photoelectric conversion unit 41 of the focus detection pixel 11 and the photoelectric conversion unit 41 of the focus detection pixel 13 respectively, are different. Moreover, the position of the reflecting portion 42A of the focus detection pixel 11 and the position of the reflecting portion 42B of the focus detection pixel 13, with respect to the optical axis of the micro lens 40 of the focus detection pixel 11 and the optical axis of the micro lens 40 of the focus detection pixel 13 respectively, are different.

In a plane (the XY plane) that intersects the direction in which light is incident (i.e. the -Z axis direction), the reflecting portion 42A of the focus detection pixel 11 is provided in a region that is toward the -X axis side from the center of the photoelectric conversion unit 41 of the focus detection pixel 11. Furthermore, in the XY plane, among the regions subdivided by a line that is parallel to a line passing through the center of the photoelectric conversion unit 41 of the focus detection pixel 11 and extending along the Y axis direction, at least a portion of the reflecting portion 42A of the focus detection pixel 11 is provided in the region toward the -X axis side. To put it in another manner, in the XY plane, among the regions subdivided by a line that is orthogonal to the line CL in Fig. 4 and that is parallel to the Y axis, at least a portion of the reflecting portion 42A of the focus detection pixel 11 is provided in the region toward the -X axis side.

On the other hand, in a plane (the XY plane) that intersects the direction in which light is incident (i.e. the -Z axis direction), the reflecting portion 42B of the focus detection pixel 13 is provided in a region that is toward the +X axis side from the center of the photoelectric conversion unit 41 of the focus detection pixel 13. Furthermore, in the XY plane, among the regions that are subdivided by a line that is parallel to a line passing through the center of the photoelectric conversion unit 41 of the focus detection pixel 13 and extending along the Y axis direction, at least a portion of the reflecting portion 42B of the focus detection pixel 13 is provided in the region toward the +X axis side. To put it in another manner, in the XY plane, among the regions that are subdivided by a line that is orthogonal to the line CL in Fig. 4 and is parallel to the Y axis, at least a portion of the reflecting portion 42B of the focus detection pixel 13 is provided in the region toward the +X axis side.

The explanation of the relationship between the positions of the reflecting portion 42A and the reflecting portion 42B of the focus detection pixels 11, 13 and the adjacent pixels is as follows. That is, in a direction that intersects the direction in which light is incident (i.e., in the example of Fig. 3, in the X axis direction or in the Y axis direction), the respective reflecting portions 42A and 42B of the focus detection pixels 11, 13 are provided at different distances from adjacent pixels. In concrete terms, the reflecting portion 42A of the focus detection pixel 11 is provided at a first distance D1 from the adjacent imaging pixel 12 on its right in the X axis direction. And the reflecting portion 42B of the focus detection pixel 13 is provided at a second distance D2, which is different from the above first distance D1, from the adjacent imaging pixel 12 on its right in the X axis direction.

It should be understood that a case in which the first distance D1 and the second distance D2 are both substantially zero will also be acceptable. Moreover, instead of representing the positions of the reflecting portion 42A of the focus detection pixel 11 and the reflecting portion 42B of the focus detection pixel 13 in the XY plane by the distances from the side edge portions of those reflecting portions to the adjacent imaging pixels on the right, it would also be acceptable to represent them by the distances from the center positions upon those reflecting portions to some other pixels (for example, to the adjacent imaging pixels on the right).

Furthermore, it would also be acceptable to represent the positions of the focus detection pixel 11 and the focus detection pixel 13 in the XY plane by the distances from the center positions upon their reflecting portions to the center positions on the same pixels (for example, to the centers of the corresponding photoelectric conversion units 41). Yet further, it would also be acceptable to represent those positions by the distances from the center positions upon the reflecting portions to the optical axes of the micro lenses 40 of the same pixels.

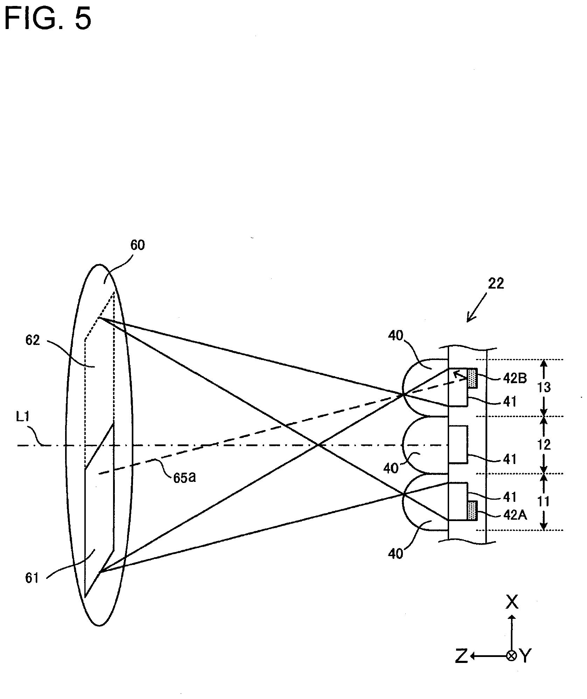

Fig. 5 is a figure for explanation of ray bundles incident upon the focus detection pixels 11, 13. The illustration shows a single unit consisting of two focus detection pixels 11, 13 and an imaging pixel 12 sandwiched between them. Directing attention to the focus detection pixel 13 of Fig. 5, a first ray bundle that has passed through a first pupil region 61 of the exit pupil 60 of the imaging optical system 31 (refer to Fig. 1) and a second ray bundle that has passed through a second pupil region 62 of that exit pupil 60 are incident upon the photoelectric conversion unit 41 via the micro lens 40. Moreover light among the first ray bundle that is incident upon the photoelectric conversion unit 41 and that has passed through the photoelectric conversion unit 41 is reflected by the reflecting portion 42B and is then again incident upon the photoelectric conversion unit 41 for a second time.

It should be understood that, in Fig. 5, light that passes through the first pupil region 61 and passes through the micro lens 40 and the photoelectric conversion unit 41 of the focus detection pixel 13, and that is then reflected back by the reflecting portion 42B and is then again incident upon the photoelectric conversion unit 41 for a second time, is schematically shown by the broken line 65a.

The signal Sig(13) obtained by the focus detection pixel 13 can be expressed by the following Equation (1):

$$Sig(13) = S1 + S2 + S1' \dots (1)$$

Here, the signal S1 is a signal based upon an electrical charge resulting from photoelectric conversion of the first ray bundle that has passed through the first pupil region 61 to be incident upon the photoelectric conversion unit 41. Moreover, the signal S2 is a signal based upon an electrical charge resulting from photoelectric conversion of the second ray bundle that has passed through the second pupil region 62 to be incident upon the photoelectric conversion unit 41. And the signal S1' is a signal based upon an electrical charge resulting from photoelectric conversion of the light, among the first ray bundle that has passed through the photoelectric conversion unit 41, that has been reflected by the reflecting portion 42B and has again been incident upon the photoelectric conversion unit 41 for a second time.

Now directing attention to the focus detection pixel 11 of Fig. 5, a first ray bundle that has passed through the first pupil region 61 of the exit pupil 60 of the imaging optical system 31 (refer to Fig. 1) and a second ray bundle that has passed through the second pupil region 62 of that exit pupil 60 are incident upon the photoelectric conversion unit 41 via the micro lens 40. Moreover light among the second ray bundle that is incident upon the photoelectric conversion unit 41 and that has passed through the photoelectric conversion unit 41 is reflected by the reflecting portion 42A and is then again incident upon the photoelectric conversion unit 41 for a second time.

Moreover, the signal Sig(11) obtained by the focus detection pixel 11 can be expressed by the following Equation (2):

$$Sig(11) = S1 + S2 + S2' \dots (2)$$

Here, the signal S1 is a signal based upon an electrical charge resulting from photoelectric conversion of the first ray bundle that has passed through the first pupil region 61 to be incident upon the photoelectric conversion unit 41. Moreover, the signal S2 is a signal based upon an electrical charge resulting from photoelectric conversion of the second ray bundle that has passed through the second pupil region 62 to be incident upon the photoelectric conversion unit 41. And the signal S2' is a signal based upon an electrical charge resulting from photoelectric conversion of the light, among the second ray bundle that has passed through the photoelectric conversion unit 41, that has been reflected by the reflecting portion 42A and has again been incident upon the photoelectric conversion unit 41 for a second time.

And, directing attention to the focus detection pixel 12 of Fig. 5, a first ray bundle that has passed through the first pupil region 61 of the exit pupil 60 of the imaging optical system 31 (refer to Fig. 1) and a second ray bundle that has passed through the second pupil region 62 of that exit pupil 60 are incident upon the photoelectric conversion unit 41 via the micro lens 40.

And the signal Sig(12) obtained by the imaging pixel 12 may be given by the following Equation (3):

$$ Sig(12) = S1 + S2 \ .... \ (3) $$

Here, the signal S1 is a signal based upon an electrical charge resulting from photoelectric conversion of the first ray bundle that has passed through the first pupil region 61 to be incident upon the photoelectric conversion unit 41. Moreover, the signal S2 is a signal based upon an electrical charge resulting from photoelectric conversion of the second ray bundle that has passed through the second pupil region 62 to be incident upon the photoelectric conversion unit 41.

Generation of the Image Data

The image generation unit 21b of the body control unit 21 generates image data related to an image of the photographic subject on the basis of the signal Sig(12) described above from the imaging pixel 12, the signal Sig(11) described above from the focus detection pixel 11, and the signal Sig(13) described above from the focus detection pixel 13.

It should be understood that, when generating this image data, in order to suppress the influence of the signal S2' and the signal S1', or, to put it in another manner, in order to suppress differences in the amount of electric charge generated by the photoelectric conversion unit 41 of the imaging pixel 12 and the amounts of electric charge generated by the photoelectric conversion units 41 of the focus detection pixels 11, 13, it may be arranged to provide a difference between the gain applied to the signal Sig(12) from the imaging pixel 12 and the gains applied to the signal Sig(11) and to the signal Sig(13) from the focus detection pixels 11, 13 respectively. For example, it may be arranged for the gains applied to the signal Sig(11) and to the signal Sig(13) from the focus detection pixels 11, 13 respectively to be smaller, as compared to the gain applied to the signal Sig(12) from the imaging pixel 12.

Detection of the Amount of Image Deviation

The focus detection unit 21a of the body control unit 21 detects an amount of image deviation on the basis of the signal Sig(12) from the imaging pixel 12, the signal Sig(11) from the focus detection pixel 11, and the signal Sig(13) from the focus detection pixel 13. To explain an example, the focus detection unit 21a obtains a difference diff2 between the signal Sig(12) from the imaging pixel 12 and the signal Sig(11) from the focus detection pixel 11, and also obtains a difference diff1 between the signal Sig(12) from the imaging pixel 12 and the signal Sig(13) from the focus detection pixel 13. The difference diff2 corresponds to the signal S2' based upon the electric charge that has been obtained by photoelectric conversion of the light, among the second ray bundle that has passed through the photoelectric conversion unit 41 of the focus detection pixel 11, that has been reflected by the reflecting portion 42A and is again incident upon the photoelectric conversion unit 41 for a second time. In a similar manner, the difference diff1 corresponds to the signal S1' based upon the electric charge that has been obtained by photoelectric conversion of the light, among the first ray bundle that has passed through the photoelectric conversion unit 41 of the focus detection pixel 13, that has been reflected by the reflecting portion 42B and is again incident upon the photoelectric conversion unit 41 for a second time.

It will also be acceptable to arrange for the focus detection unit 21a, when calculating the differences diff2 and diff1 described above, to subtract a value obtained by multiplying the signal Sig(12) from the imaging pixel 12 by a constant value from the signals Sig(11) and Sig(13) from the focus detection pixels 11, 13.

On the basis of these differences diff2 and diff1 that have thus been obtained, the focus detection unit 21a obtains an amount of image deviation between an image due to the first ray bundle that has passed through the first pupil region 61 (refer to Fig. 5) and an image due to the second ray bundle that has passed through the second pupil region 62 (refer to Fig. 5). In other words, by considering together and combining the group of differences diff2 of the signals obtained by the plurality of units described above, and the group of differences diff1 of the signals obtained by the plurality of units described above, the focus detection unit 21a obtains information showing the intensity distributions of the plurality of images formed by the plurality of focus detection ray bundles that have respectively passed through the first pupil region 61 and through the second pupil region 62.

By executing image deviation detection calculation processing (i.e. correlation calculation processing and phase difference detection processing) upon the intensity distributions of the plurality of images described above, the focus detection unit 21a calculates the amount of image deviation of the plurality of images. Moreover, the focus detection unit 21a calculates an amount of defocusing by multiplying this amount of image deviation by a predetermined conversion coefficient. Since image deviation detection calculation and amount of defocusing calculation according to this pupil-split type phase difference detection method are per se known, accordingly detailed explanation thereof will be curtailed.

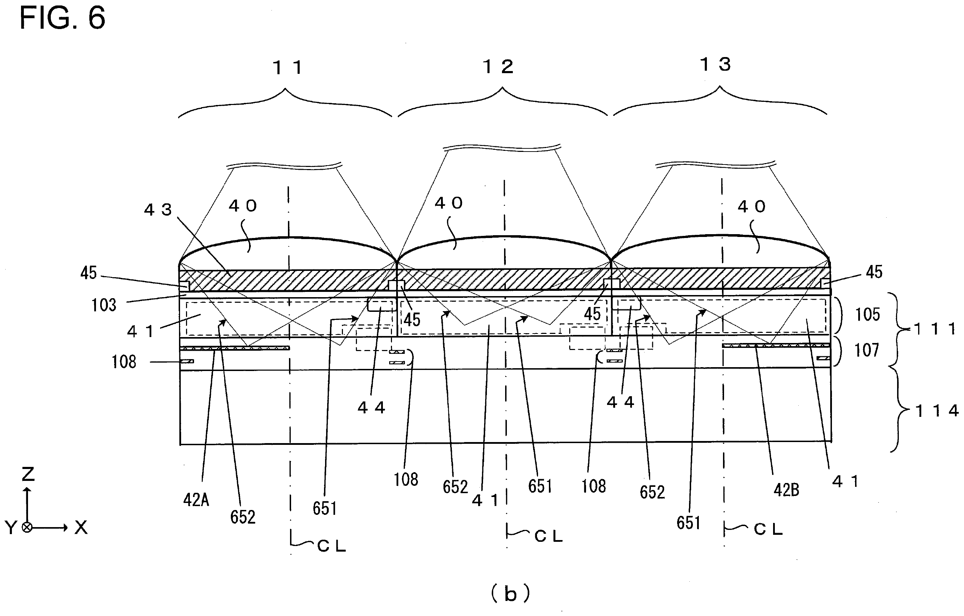

Fig. 6 is an enlarged sectional view of a single unit according to this embodiment, consisting of focus detection pixels 11, 13 and an imaging pixel 12 sandwiched between them. This sectional view is a figure in which the single unit of Fig. 3 is cut parallel to the X-Z plane. The same reference symbols are appended to structures of the imaging pixel 12 of Fig. 4(a), to structures of the focus detection pixel 11 of Fig. 4(b) and to structures of the focus detection pixel 13 of Fig. 4(c) which are the same, and explanation thereof will be curtailed. And the lines CL are lines that pass through the centers of the pixels 11, 12, and 13 (for example, through the centers of the photoelectric conversion units 41).

For example, light shielding layers 45 are provided between the various pixels, so as to suppress leakage of light that has passed through the micro lenses 40 of the pixels to the photoelectric conversion units 41 of adjacent pixels. It should be understood that element separation portions not shown in the figures may be provided between the photoelectric conversion units 41 of the pixels in order to separate them, so that leakage of light or electric charge within the semiconductor layer to adjacent pixels can be suppressed.

Explanation of Discharge (Drain)

A process of discharge (drain), in which unnecessary electric charge is discharged, will now be explained with reference to Fig. 6. In the signal Sig(11) described above, the phase difference information that is required for phase difference detection consists of the signal S2 and the signal S2' that are based upon the second ray bundle 652 that has passed through the second pupil region 62 (refer to Fig. 5). In other words, in the signal Sig(11) from the focus detection pixel 11, the signal S1 that is based upon the first ray bundle 651 that has passed through the first pupil region 61 (refer to Fig. 5) is unnecessary for phase difference detection.

In a similar manner, in the signal Sig(13) described above, the phase difference information that is required for phase difference detection consists of the signal S1 and the signal S1' that are based upon the first ray bundle 651 that has passed through the first pupil region 61 (refer to Fig. 5). In other words, in the signal Sig(13) from the focus detection pixel 13, the signal S2 that is based upon the second ray bundle 652 that has passed through the second pupil region 62 (refer to Fig. 5) is unnecessary for phase difference detection.

Accordingly, in this embodiment, in order to suppress the output of the unnecessary signal S1 from the output unit 106 of the focus detection pixel 11, a discharge unit 44 is provided that serves as a second output unit for outputting unnecessary electric charge. This discharge unit 44 is provided in a position in which it can easily absorb electric charge generated by photoelectric conversion of the first ray bundle 651 that has passed through the first pupil region 61. The focus detection pixel 11, for example, has the discharge unit 44 at the upper portion of the photoelectric conversion unit 41 (i.e. the portion toward the +Z axis direction), in a region on the opposite side of the reflecting portion 42A with respect to the line CL (i.e. in a region to the +X axis side thereof). The discharge unit 44 discharges a part of the electric charge based upon the light that is not required by the focus detection pixel 11 for phase difference detection (i.e. based upon the first ray bundle 651). For example, the discharge unit 44 may be controlled so as to continue discharging the electric charge only if the signal for focus detection is being generated by the focus detection pixel 11 for automatic focus adjustment (AF). The limitation of the time period for discharge of electric charge by the discharge unit 44 is due to considerations of power economy.

The signal Sig(11) obtained due to the focus detection pixel 11 that is provided with the discharge unit 44 may be derived according to the following Equation (4):

$$\text{Sig}(11) = S1(1\text{-}A) + S2(1\text{-}B) + S2'(1\text{-}B') \ ... \ (4)$$

Here, the coefficient of absorption by the discharge unit 44 for the unnecessary light that is not required for phase difference detection (i.e. the first ray bundle 651) is termed A, the coefficient of absorption by the discharge unit 44 for the light that is required for phase difference detection (i.e. the second ray bundle 652) is termed B, and the coefficient of absorption by the discharge unit 44 for the light reflected by the reflecting portion 42A is termed B'. It should be understood that A>B>B'.

According to the above Equation (4), due to the provision of the discharge unit 44, as compared with the case of Equation (2) above, it is possible to reduce the proportion in the signal Sig(11) occupied by the signal S1 that is based upon the light that is not required by the focus detection pixel 11 (i.e. upon the first ray bundle 651 that has passed through the first pupil region 61). Due to this, it is possible to obtain an image sensor 22 with which the S/N ratio is increased, and with which the accuracy of pupil-split type phase difference detection is enhanced.

In a similar manner, in the present embodiment, in order to suppress the output of the unnecessary signal S2 from the output unit 106 of the focus detection pixel 13, a discharge unit 44 is provided that serves as a second output unit for outputting unnecessary electric charge. This discharge unit 44 is provided in a position in which it can easily absorb electric charge generated by photoelectric conversion of the second ray bundle 652 that has passed through the second pupil region 62. The focus detection pixel 13, for example, has the discharge unit 44 at the upper portion of the photoelectric conversion unit 41 (i.e. the portion toward the +Z axis direction), in a region on the opposite side of the reflecting portion 42B with respect to the line CL (i.e. in a region to the -X axis side thereof). The discharge unit 44 discharges a part of the electric charge based upon the light that is not required by the focus detection pixel 13 for phase difference detection (i.e. upon the second ray bundle 652). For example, the discharge unit 44 may be controlled so as to continue discharging the electric charge only if the signal for focus detection is being generated by the focus detection pixel 13 for automatic focus adjustment (AF). The limitation of the time period for discharge of electric charge by the discharge unit 44 is due to considerations of power economy.

The signal Sig(13) obtained due to the focus detection pixel 13 that is provided with the discharge unit 44 may be derived according to the following Equation (5):

$$Sig(13) = S1(1-B) + S2(1-A) + S1'(1-B') \ ... \ (5)$$

Here, the coefficient of absorption by the discharge unit 44 for the light that is unnecessary for phase difference detection (i.e. the second ray bundle 652) is termed A, the coefficient of absorption by the discharge unit 44 for the light that is required for phase difference detection (i.e. the first ray bundle 651) is termed B, and the coefficient of absorption by the discharge unit 44 for the light reflected by the reflecting portion 42B is termed B'. It should be understood that A>B>B'.

According to the above Equation (5), due to the provision of the discharge unit 44, as compared with the case of Equation (1) above, it is possible to reduce the proportion in the signal Sig(13) occupied by the signal S2 that is based upon the light that is not required by the focus detection pixel 13 (i.e. upon the second ray bundle 652 that has passed through the second pupil region 62). Due to this, it is possible to obtain an image sensor 22 with which the S/N ratio is increased, and with which the accuracy of pupil-split type phase difference detection is enhanced.

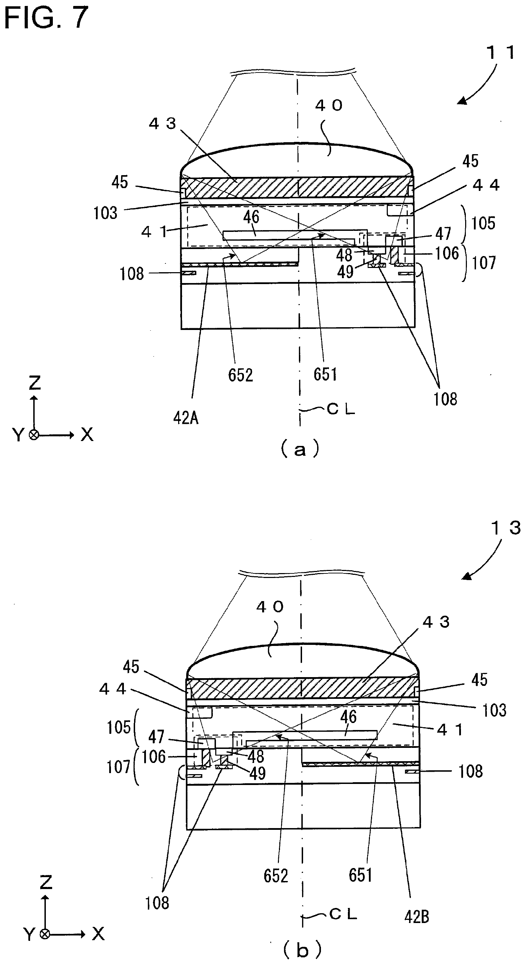

Fig. 7(a) is an enlarged sectional view of the focus detection pixel 11 of Fig. 6. Moreover, Fig. 7(b) is an enlarged sectional view of the focus detection pixel 13 of Fig. 6. These sectional views are, respectively, figures in which the focus detection pixels 11, 13 are cut parallel to the X-Z plane. Both an n+ region 46 and an n+ region 47 are formed in the semiconductor layer 105 by using an N type impurity, but this feature is not shown in Figs. 4 and 6. The n+ region 46 and the n+ region 47 function as a source region and a drain region for the transfer transistor. Moreover, an electrode 48 is formed on the wiring layer 107 via an insulation layer, and functions as a gate electrode for the transfer transistor (i.e. as a transfer gate).

The n+ region 46 also functions as a portion of the photo-diode. The gate electrode 48 is connected to wiring 108 provided in the wiring layer 107 via a contact 49. The wiring systems 108 of the focus detection pixel 11, the imaging pixel 12, and the focus detection pixel 13 may be connected together, according to requirements.

The photo-diode of the photoelectric conversion unit 41 generates an electric charge according to the incident light. This electric charge that has thus been generated is transferred via the transfer transistor described above to an n+ region 47, which functions as a FD (floating diffusion) region. This FD region receives the electric charge and converts it into a voltage. And a signal corresponding to the electrical potential of the FD region is amplified by an amplification transistor in the output unit 106. And the resulting signal is read out (i.e. outputted) via the wiring 108.

Arrangement

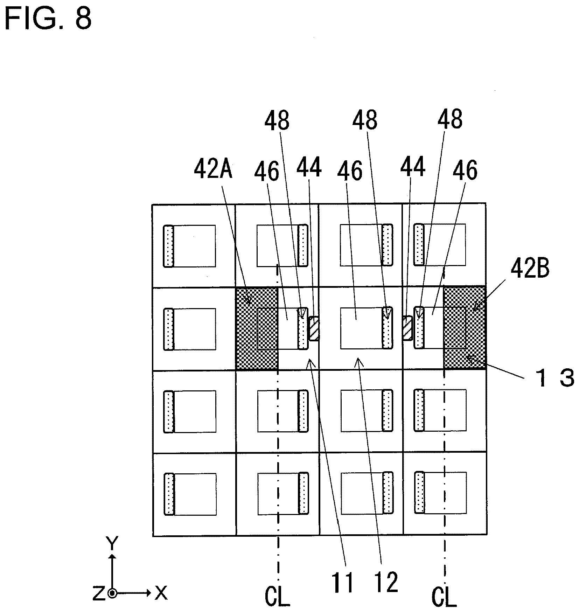

Fig. 8 is a plan view schematically showing the arrangement of focus detection pixels 11, 13 and an imaging pixel 12 sandwiched between two of them. From within the plurality of pixels arrayed within the region 22a (refer to Fig. 3) of the image sensor 22 that generates an image, a total of sixteen pixels arranged in a four row by four column array are extracted and illustrated in Fig. 8. In Fig. 8, each single pixel is shown as an outlined white square. As described above, the focus detection pixels 11, 13 are both disposed at positions for R pixels.

The gate electrodes 48 of the transfer transistors in the imaging pixel 12 and the focus detection pixels 11, 13 are, for example, shaped as rectangles that are longer in the column direction (i.e. in the Y axis direction). And the gate electrode 48 of the focus detection pixel 11 is disposed more toward the +X axis direction than the center of its photoelectric conversion unit 41 (i.e. than the line CL). In other words, in a plane that intersects the direction of light incidence (i.e. the -Z axis direction) and that is parallel to the direction of arrangement of the focus detection pixels 11, 13 (i.e. the +X axis direction), the gate electrode of the focus detection pixel 11 is provided more toward the direction of arrangement (i.e. the +X axis direction) than the center of the photoelectric conversion unit 41 (i.e. than the line CL).

It should be understood that, as described above, the n+ regions 46 formed in the pixels are portions of the photo-diodes.

On the other hand, the gate electrode 48 of the focus detection pixel 13 is disposed more toward the -X axis direction than the center of its photoelectric conversion unit 41 (i.e. than the line CL). In other words, in a plane that intersects the direction of light incidence (i.e. the -Z axis direction) and that is parallel to the direction of arrangement of the focus detection pixels 11, 13 (i.e. the +X axis direction), the gate electrode of the focus detection pixel 13 is provided more toward the direction opposite (i.e. the -X axis direction) to the direction of arrangement (i.e. the +X axis direction) than the center of the photoelectric conversion unit 41 (i.e. than the line CL).

The reflecting portion 42A of the focus detection pixel 11 is provided at a position that corresponds to the left half of the pixel. Moreover, the reflecting portion 42B of the focus detection pixel 13 is provided at a position that corresponds to the right half of the pixel. In other words, in a plane that intersects the direction of light incidence (i.e. the -Z axis direction), the reflecting portion 42A of the focus detection pixel 11 is provided in a region more toward the direction opposite (i.e. the -X axis direction) to the direction of arrangement (i.e. the +X axis direction) of the focus detection pixels 11, 13 than the center of the photoelectric conversion unit 41 of the focus detection pixel 11 (i.e. than the line CL). And, in a plane that intersects the direction of light incidence (i.e. the -Z axis direction), the reflecting portion 42B of the focus detection pixel 13 is provided in a region more toward the direction of arrangement (i.e. the +X axis direction) of the focus detection pixels 11, 13 than the center of the photoelectric conversion unit 41 of the focus detection pixel 13 (i.e. than the line CL).

To put it in another manner, in a plane that intersects the direction of light incidence (i.e. the -Z axis direction), the reflecting portion 42A of the focus detection pixel 11 is provided in the region, among the regions divided by the line CL that passes through the center of the photoelectric conversion unit 41 of the focus detection pixel 11, that is more toward the direction opposite (i.e. the -X axis direction) to the direction of arrangement (i.e. the +X axis direction) of the focus detection pixels 11, 13. In a similar manner, in a plane that intersects the direction of light incidence (i.e. the -Z axis direction), the reflecting portion 42B of the focus detection pixel 13 is provided in the region, among the regions divided by the line CL that passes through the center of the photoelectric conversion unit 41 of the focus detection pixel 13, that is more toward the direction of arrangement of the focus detection pixels 11, 13 (i.e. the +X axis direction).

In Fig. 8, the discharge units 44 of the focus detection pixels 11, 13 are illustrated as being positioned on the sides opposite to the reflecting portions 42A, 42B, in other words as being at positions that do not overlap the reflecting portions 42A, 42B in plan view. This means that, in the focus detection pixel 11, the discharge unit 44 is provided at a position such that the reflecting portion 42A can easily absorb the first ray bundle 651 (refer to Fig. 6(a)). Moreover it means that, in the focus detection pixel 13, the discharge unit 44 is provided at a position such that the reflecting portion 42B can easily absorb the second ray bundle 652 (refer to Fig. 6(b)).

Furthermore, in Fig. 8, the gate electrode 48 and the reflecting portion 42A of the focus detection pixel 13 and the gate electrode 48 and the reflecting portion 42B of the focus detection pixel 11 are arranged symmetrically left and right (i.e. symmetrically with respect to the imaging pixel 12 that is sandwiched between the focus detection pixels 11, 13). For example, the shapes, the areas, and the positions of the gate electrodes 48, and the shapes, the areas, and the positions of the reflecting portions 42A and 42B, are aligned with each another. Due to this, light incident upon the focus detection pixel 11 and upon the focus detection pixel 13 is reflected in a similar manner by their respective reflecting portion 42A and reflecting portion 42B, and is photoelectrically converted in a similar manner. Due to this, the signal Sig(11) and the signal Sig(13) that are suitable for phase difference detection are outputted.

Furthermore, in the plan view of Fig. 8, the gate electrodes 48 of the transfer transistors of the focus detection pixels 11, 13 are illustrated as being positioned on the opposite sides from the reflecting portions 42A, 42B with respect to the line CL, in other words as being at positions where, in plan view, they do not overlap with the reflecting portions 42A, 42B. This means that, in the focus detection pixel 11, the gate electrode 48 is provided away from the optical path along which light that has passed through the photoelectric conversion unit 41 is incident upon the reflecting portion 42A. Moreover it means that, in the focus detection pixel 13, the gate electrode 48 is provided away from the optical path along which light that has passed through the photoelectric conversion unit 41 is incident upon the reflecting portion 42B.

As described above, the light that has passed through the photoelectric conversion unit 41 reaches the reflecting portion 42A, 42B. It is desirable for other members not to be disposed upon the optical path of this light. For example, if some other member such as the gate electrode 48 or the like is present upon the optical path of the light that reaches the reflecting portion 42A, 42B, then reflection and/or absorption will be caused by this member. If reflection and/or absorption occurs, then there is a possibility that a change in the amount of the electric charge generated by the photoelectric conversion unit 41 will occur when the light that has been reflected by the reflecting portion 42A, 42B is again incident upon the photoelectric conversion unit 41. In concrete terms, the signal S2' based upon the light upon the focus detection pixel 11 that is required for phase difference detection (i.e. the second ray bundle 652) may change, or the signal S1' based upon the light upon the focus detection pixel 13 that is required for phase difference detection (i.e. the first ray bundle 651) may change.

However in the present embodiment, in the focus detection pixel 11 and the focus detection pixel 13, other members such as the gate electrodes 48 and so on are disposed away from the optical paths along which light that has passed through the photoelectric conversion units 41 is incident upon the reflecting portions 42A, 42B. Due to this, unlike the case in which the gate electrodes 48 are present upon that optical path, it is possible to suppress the influence of reflection and/or absorption by the gate electrodes 48, so that it is possible to obtain signals Sig(11) and Sig(13) that are suitable for phase difference detection.

According to the first embodiment described above, the following operations and beneficial effects are obtained.

(1) The image sensor 22 comprises the plurality of focus detection pixels 11 (13), each of which includes a photoelectric conversion unit 41 that performs photoelectric conversion of incident light and generates electric charge, a reflecting portion 42A (42B) that reflects light that has passed through the photoelectric conversion unit 41 back to the photoelectric conversion unit 41, and a discharge unit 44 that discharges a portion of the electric charge generated during photoelectric conversion.

Due to this, it is possible to reduce the proportion occupied in the signal Sig(11) (Sig(13)) by the signal S1 (S2) based upon light that is not necessary for the focus detection pixel 11 (13) (in the case of the focus detection pixel 11, the first ray bundle 651 that has passed through the first pupil region 61 (refer to Fig. 5) of the exit pupil 60 of the imaging optical system 31 (refer to Fig. 1), and, in the case of the focus detection pixel 13, the second ray bundle 652 that has passed through the second pupil region 62 of the exit pupil 60). Due to this the S/N ratio is increased, and an image sensor 22 is obtained with which the accuracy of pupil-split type phase difference detection is enhanced.

(2) With the image sensor 22 of (1) described above, the reflecting portion 42A (42B) of the focus detection pixel 11 (13) reflects a portion of the light passing through the photoelectric conversion unit 41. And the discharge unit 44 discharges a portion of the electric charge generated on the basis of the light that is not a subject for reflection by the reflecting portion 42A (42B). For example, the discharge unit 44 may be provided in a position that does not overlap with the reflecting portion 42A (42B) in the plan view of Fig. 8. Since, due to this, it becomes easier for light that is not required by the focus detection pixel 11 (13) to become the subject of absorption (discharge), accordingly it is possible to reduce the proportion occupied in the signal Sig(11) (Sig (13)) occupied by the signal S1 (S2) based upon light that is not required.

(3) With the image sensor 22 of (1) described above, each of the reflecting portions 42A (42B) of the focus detection pixels 11 (13) is, for example, disposed in a position where it reflects one ray bundle, among the first and second ray bundles 651, 652 that respectively pass through the first and second pupil regions 61, 62 of the exit pupil 60 described above. The photoelectric conversion unit 41 photoelectrically converts the ray bundle 651, 652 and the ray bundle reflected by the reflecting portion 42A (42B). And the discharge unit discharges the portion of the electric charge generated on the basis of the other ray bundle, among the first and the second ray bundles 651, 652. Due to this, in the focus detection pixel 11 (13), it is possible to reduce the proportion occupied in the signal Sig(11) (Sig(13)) by the signal S1 (S2) based upon the light that is not required.

(4) With the image sensor 22 described above, in the photoelectric conversion unit 41, the discharge unit 44 of the focus detection pixel 11 (13) is disposed in a region of the photoelectric conversion unit 41 that is closer to its surface upon which light is incident than its surface where light that has passed through the photoelectric conversion unit 41 is emitted, for example in its upper portion (its portion in the +Z axis direction) in Fig. 7. Due to this, it is possible more easily for light that is not required by the focus detection pixel 11 (13) to be the subject of absorption (or discharge).

(5) The focus adjustment device mounted to the camera 1 comprises an image sensor 22 as described in (3) or in (4) above, a body control unit 21 that extracts a signal for detecting the focused position of the imaging optical system 31 (refer to Fig. 1) from the plurality of signals Sig(11) (Sig(13)) based upon electric charges generated by the plurality of focus detection pixels 11 (13) of the image sensor 22, and a lens control unit 32 that adjusts the focused position of the imaging optical system 31 on the basis of the signal extracted by the body control unit 21. Due to this, a focus adjustment device is obtained with which the accuracy of pupil-split type phase difference detection is enhanced.

(6) With the focus adjustment device of (5) described above, the image sensor 22 comprises the plurality of imaging pixels 12 having the photoelectric conversion units 41 that generate electric charge by photoelectrically converting the first and second ray bundles 651, 652. And the body control unit 21 subtracts the plurality of signals Sig(12) based upon the electric charges generated by the plurality of imaging pixels 12 from the plurality of signals Sig(11) (Sig(13)) from the focus detection pixels 11 (13). By performing this subtraction processing, which is simple processing, it is possible to extract the high frequency component signals, including fine variations of contrast due to the pattern upon the photographic subject, from the plurality of signals Sig(11) (Sig(13)).

The following modifications are also within the scope of the present invention; and it would also be possible to combine one or a plurality of the following variant embodiments with the embodiment described above.

Variant Embodiment 1 of Embodiment One

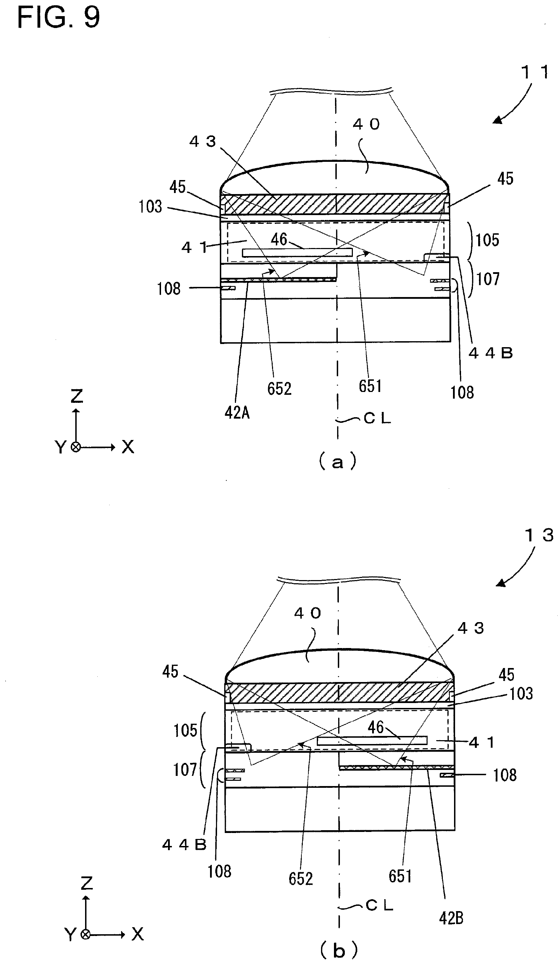

It would also be possible to locate the discharge unit 44 provided to the focus detection pixel 11 and the discharge unit 44 provided to the focus detection pixel 13 in positions that are different from those described for the case of the first embodiment. Fig. 9(a) is an enlarged sectional view of one of the focus detection pixels 11 according to a first variant embodiment of the first embodiment. Moreover, Fig. 9(b) is an enlarged sectional view of one of the focus detection pixels 13 according to this first variant embodiment of the first embodiment. Both of these sectional views of the focus detection pixels 11, 13 show them as cut parallel to the X-Z plane. To structures that are similar to structures of the focus detection pixel 11 of Fig. 7(a) according to the first embodiment and to structures of the focus detection pixel 13 of Fig. 7(b) according to the first embodiment, the same reference symbols are appended, and explanation thereof will be curtailed.

In Fig. 9(a), for example, the focus detection pixel 11 has its discharge unit 44B at the lower portion (in the -Z axis direction) of its photoelectric conversion unit 41 in a region on the opposite side from the reflecting portion 42A with respect to the line CL (i.e. in a region toward the +X axis direction). Due to the provision of this discharge unit 44B, a portion of the electric charge based upon the light (the first ray bundle 651) that is not required by the focus detection pixel 11 for phase difference detection is discharged. The discharge unit 44B may, for example, be controlled to continue discharging the electric charge only when a focus detection signal for automatic focus adjustment (AF) is being generated by the focus detection pixel 11.

The signal Sig(11) obtained due to the focus detection pixel 11 that is provided with the discharge unit 44B may be derived according to the following Equation (6):

$$\mathrm{Sig}(11) = S1(1-\alpha) + S2(1-\beta) + S2'(1-\beta') \dots (6)$$

Here, the coefficient of absorption by the discharge unit 44B for the unnecessary light that is not required for phase difference detection (i.e. the first ray bundle 651) is termed $\alpha$, the coefficient of absorption by the discharge unit 44B for the light that is required for phase difference detection (i.e. the second ray bundle 652) is termed $\beta$, and the coefficient of absorption by the discharge unit 44B for the light reflected by the reflecting portion 42A is termed $\beta'$. It is supposed that $\alpha > \beta > \beta'$.

According to the above Equation (6), due to the provision of the discharge unit 44B, as compared with the case of Equation (2) above, it is possible to reduce the proportion in the signal Sig(11) occupied by the signal S1 that is based upon the light that is not required by the focus detection pixel 11 (i.e. by the first ray bundle 651 that has passed through the first pupil region 61). Due to this, it is possible to obtain an image sensor 22 with which the S/N ratio is increased, and with which the accuracy of pupil-split type phase difference detection is enhanced.

In Fig. 9(b), for example, the focus detection pixel 13 has its discharge unit 44B at the lower portion (in the -Z axis direction) of its photoelectric conversion unit 41 in a region on the opposite side from the reflecting portion 42B with respect to the line CL (i.e. in a region toward the -X axis direction). Due to the provision of this discharge unit 44B, a portion of the electric charge based upon the light (the second ray bundle 652) that is not needed by the focus detection pixel 13 for phase difference detection is discharged. The discharge unit 44B may, for example, be controlled to continue discharging the electric charge only when a focus detection signal for automatic focus adjustment (AF) is being generated by the focus detection pixel 11.

The signal Sig(13) obtained due to the focus detection pixel 13 that is provided with this discharge unit 44B may be derived according to the following Equation (7):

$$\mathrm{Sig}(13) = S1(1-\beta) + S2(1-\alpha) + S1'(1-\beta') \dots (7)$$

Here, the coefficient of absorption by the discharge unit 44B for the light that is not required that is not required for phase difference detection (i.e. the second ray bundle 652) is termed $\alpha$, the coefficient of absorption by the discharge unit 44B for the light that is required for phase difference detection (i.e. the first ray bundle 651) is termed $\beta$, and the coefficient of absorption by the discharge unit 44B for the light reflected by the reflecting portion 42B is termed $\beta'$. It should be understood that $\alpha > \beta > \beta'$.

According to the above Equation (7), by the provision of the discharge unit 44B, as compared with the case of Equation (1) above, it is possible to reduce the proportion in the signal Sig(13) occupied by the signal S2 that is based upon the light that is not required by the focus detection pixel 13 (i.e. by the second ray bundle 652 that has passed through the second pupil region 62). Due to this, it is possible to obtain an image sensor 22 with which the S/N ratio is increased, and with which the accuracy of pupil-split type phase difference detection is enhanced.

Arrangement

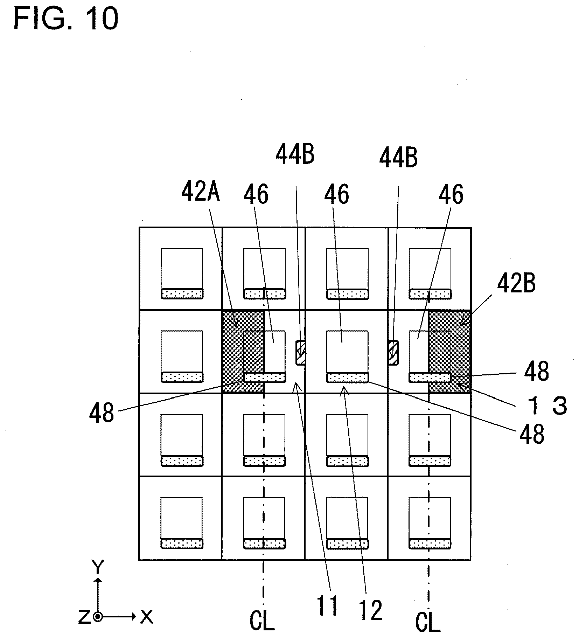

Fig. 10 is a plan view schematically showing the arrangement, in this first variant embodiment of the first embodiment, of focus detection pixels 11, 13 and an imaging pixel 12 sandwiched between two them. From the plurality of pixels arrayed within the region 22a (refer to Fig. 3) of the image sensor 22 that generates an image, a total of sixteen pixels arranged in a four row by four column array are extracted and illustrated. In Fig. 10, each single pixel is shown as an outlined white square. As described above, the focus detection pixels 11, 13 are both disposed at positions for R pixels.

The gate electrodes 48 of the transfer transistors in the imaging pixel 12 and the focus detection pixels 11, 13 are, for example, shaped as rectangles that are longer in the row direction (i.e. in the X axis direction). And the gate electrode 48 of the focus detection pixel 11 is disposed in an orientation that intersects the line CL that passes through the center of the photoelectric conversion unit 41 (i.e. along a line parallel to the X axis). In other words, the gate electrode 48 of the focus detection pixel 11 is provided so as to intersect the direction in which light is incident (i.e. the -Z axis direction) and so as to be parallel to the direction in which the focus detection pixels 11, 13 are arranged (i.e. the +X axis direction).

It should be understood that, as described above, the n+ regions 46 formed in the pixels are parts of the photodiodes.

On the other hand, the gate electrode 48 of the focus detection pixel 13 is also disposed in an orientation that intersects the line CL that passes through the center of the photoelectric conversion unit 41 (i.e. along a line parallel to the X axis). In other words, the gate electrode 48 of the focus detection pixel 13 is provided so as to intersect the direction in which light is incident (i.. the -Z axis direction) and so as to be parallel to the direction in which the focus detection pixels 11, 13 are arranged (i.e. the +X axis direction).

The reflecting portion 42A of the focus detection pixel 11 is provided at a position that corresponds to the left half of the pixel. Moreover, the reflecting portion 42B of the focus detection pixel 13 is provided at a position that corresponds to the right half of the pixel. In other words, in a plane that intersects the direction of light incidence (i.e. the -Z axis direction), the reflecting portion 42A of the focus detection pixel 11 is provided in a region more toward the direction opposite (i.e. the -X axis direction) to the direction of arrangement (i.e. the +X axis direction) of the focus detection pixels 11, 13 than the center of the photoelectric conversion unit 41 of the focus detection pixel 11 (i.e. than the line CL). And, in a similar manner, in a plane that intersects the direction of light incidence (i.e. the -Z axis direction), the reflecting portion 42B of the focus detection pixel 13 is provided in a region more toward the direction of arrangement (i.e. the +X axis direction) of the focus detection pixels 11, 13 than the center of the photoelectric conversion unit 41 of the focus detection pixel 13 (i.e. than the line CL).

In Fig. 10, the discharge units 44B of the focus detection pixels 11, 13 are illustrated as being positioned on the sides opposite to the reflecting portions 42A, 42B, in other words as being at positions that do not overlap the reflecting portions 42A, 42B in plan view. This means that, in the focus detection pixel 11, the discharge unit 44B is provided at a position such that the reflecting portion 42A can easily absorb the first ray bundle 651 (refer to Fig. 7(a)). Moreover it means that, in the focus detection pixel 13, the discharge unit 44B is provided at a position such that the reflecting portion 42B can easily absorb the second ray bundle 652 (refer to Fig. 7(b)).

Furthermore, in Fig. 10, the gate electrode 48 and the reflecting portion 42A of the focus detection pixel 11 and the gate electrode 48 and the reflecting portion 42B of the focus detection pixel 13 are arranged symmetrically left and right (i.e. symmetrically with respect to the imaging pixel 12 that is sandwiched between the focus detection pixels 11, 13). For example, the shapes, the areas, and the positions of the gate electrodes 48, and the shapes, the areas, and the positions and so on of the reflecting portions 42A and 42B, are aligned with each another. Due to this, light incident upon the focus detection pixel 11 and the focus detection pixel 13 is reflected in a similar manner by their respective reflecting portion 42A and reflecting portion 42B, and is photoelectrically converted in a similar manner. Due to this, the signal Sig(11) and the signal Sig(13) that are suitable for phase difference detection are outputted.

Furthermore, in the plan view of Fig. 10, the gate electrodes 48 of the transfer transistors of the focus detection pixels 11, 13 are illustrated as being positioned at positions where, in plan view, the reflecting portions 42A, 42B and halves of the gate electrodes 48 overlap. This means that, in the focus detection pixel 11, half of the gate electrode 48 is positioned upon the optical path along which light that has passed through the photoelectric conversion unit 41 is incident upon the reflecting portion 42A, and the remaining half of the gate electrode 48 is positioned away from the optical path described above. And in the focus detection pixel 13, in the same manner, half of the gate electrode 48 is positioned upon the optical path along which light that has passed through the photoelectric conversion unit 41 is incident upon the reflecting portion 42B, and the remaining half of the gate electrode 48 is positioned away from the optical path described above.

Due to this, light that is incident upon the focus detection pixel 11 and light that is incident upon the focus detection pixel 13 are reflected and photoelectrically converted under the same conditions, so that it is possible to obtain a signal Sig(11) and a signal Sig(13) that are suitable for phase difference detection.

According to the first variant embodiment of the first embodiment described above, the following operation and beneficial effect is obtained.

With the image sensor 22 of Fig. 9, the discharge unit 44B of the focus detection pixel 11 (13) is disposed in a region of the photoelectric conversion unit 41, for example in its lower portion (its portion in the -Z axis direction), that is closer to its surface from which light that has passed through the photoelectric conversion unit 41 is emitted than its surface upon which light is incident. Due to this, it is possible more easily for light that is not required by the focus detection pixel 11 (13) to be the subject of absorption (or discharge).

Variant Embodiment 2 of Embodiment One

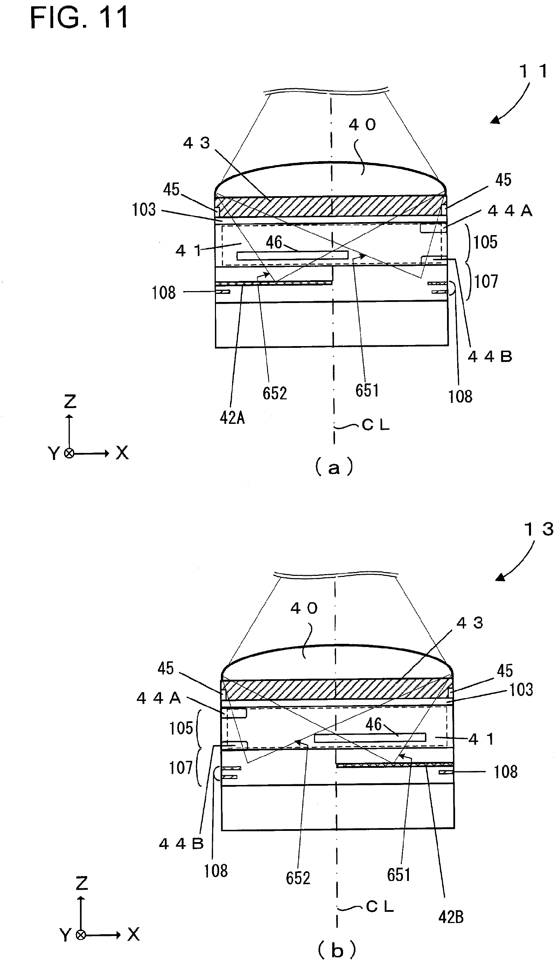

In the focus detection pixel 11 and the focus detection pixel 13, it would also be acceptable to provide, respectively, a discharge unit 44A similar to the discharge unit 44 provided in the first embodiment, and a discharge unit 44B as provided to the first variant embodiment of the first embodiment. Fig. 11(a) is an enlarged sectional view of one of the focus detection pixels 11 according to a second variant embodiment of the first embodiment. Moreover, Fig. 11(b) is an enlarged sectional view of one of the focus detection pixels 13 according to this second variant embodiment of the first embodiment. Both of these sectional views of the focus detection pixels 11, 13 show them as cut parallel to the X-Z plane. To structures that are similar to structures of the focus detection pixels 11 of Fig. 7(a) and Fig. 9(a) and to structures of the focus detection pixels 13 of Fig. 7(b) and Fig. 9(b), the same reference symbols are appended, and explanation thereof will be curtailed.

The signal Sig(11) obtained due to the focus detection pixel 11 that is provided with the discharge unit 44A and the discharge unit 44B may be derived according to the following Equation (8):

$$\mathrm{Sig}(11) = (S2+S2')(1\text{-}B\text{-}\beta) + S1(1\text{-}A\text{-}\alpha) \ldots (8)$$

Here, the coefficient of absorption by the discharge unit 44A for the unnecessary light that is not required for phase difference detection (i.e. the first ray bundle 651) is termed A, the coefficient of absorption by the discharge unit 44B is termed $\alpha$, the coefficient of absorption by the discharge unit 44A for the light that is required for phase difference detection (i.e. the second ray bundle 652) is termed B, and the coefficient of absorption by the discharge unit 44B is termed $\beta$. It should be understood that A>B and $\alpha>\beta$.

According to the above Equation (8), due to the provision of the discharge unit 44A and the discharge unit 44B, as compared with the case of Equation (2) above, it is possible to reduce the proportion in the signal Sig(11) occupied by the signal S1 that is based upon the light that is not required by the focus detection pixel 11 (i.e. by the first ray bundle 651 that has passed through the first pupil region 61). Due to this, it is possible to obtain an image sensor 22 with which the S/N ratio is increased, and with which the accuracy of pupil-split type phase difference detection is enhanced.

On the other hand, the signal Sig(13) obtained due to the focus detection pixel 13 that is provided with the discharge unit 44A and the discharge unit 44B may be derived according to the following Equation (9):

$$\mathrm{Sig}(13) = (S1+S1')(1\text{-}B\text{-}\beta) + S2(1\text{-}A\text{-}\alpha) \ldots (9)$$

Here, the coefficient of absorption by the discharge unit 44A for the unnecessary light that is not required for phase difference detection (i.e. the second ray bundle 652) is termed A, the coefficient of absorption by the discharge unit 44B is termed $\alpha$, the coefficient of absorption by the discharge unit 44A for the light that is required for phase difference detection (i.e. the first ray bundle 651) is termed B, and the coefficient of absorption by the discharge unit 44B is termed $\beta$. It should be understood that A>B and $\alpha>\beta$.

According to the above Equation (9), due to the provision of the discharge unit 44A and the discharge unit 44B, as compared with the case of Equation (1) above, it is possible to reduce the proportion in the signal Sig(13) occupied by the signal S2 that is based upon the light that is not required by the focus detection pixel 13 (i.e. by the second ray bundle 652 that has passed through the second pupil region 62). Due to this, it is possible to obtain an image sensor 22 with which the S/N ratio is increased, and with which the accuracy of pupil-split type phase difference detection is enhanced.

Arrangement

The arrangement of the focus detection pixels 11, 13 and the imaging pixels sandwiched between them in this second variant embodiment of the first embodiment is the same as in Fig. 10. However, the discharge units 44A and the discharge units 44B are shown as overlapped in the positions of the discharge units 44B of Fig. 10.

Variant Embodiment 3 of Embodiment One

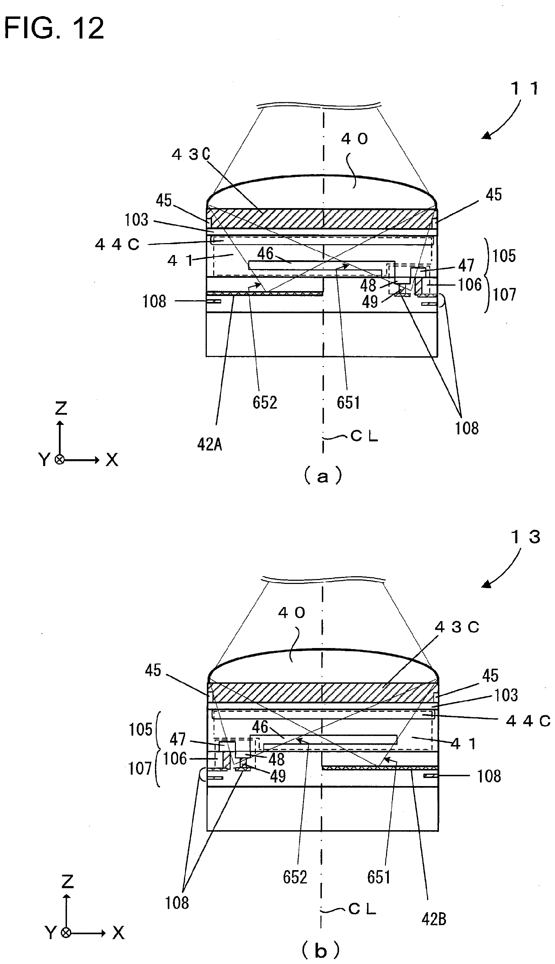

In the focus detection pixel 11 and the focus detection pixel 13, it would also be acceptable to provide discharge units 44C over almost the entire areas of the upper portions of the photoelectric conversion units 41 (i.e. their portions toward the +Z axis direction). Fig. 12(a) is an enlarged sectional view of one of the focus detection pixels 11 according to a third variant embodiment of the first embodiment. Moreover, Fig. 12(b) is an enlarged sectional view of one of the focus detection pixels 13 according to this third variant embodiment of the first embodiment. Both of these sectional views of the focus detection pixels 11, 13 are figures illustrating them as cut parallel to the X-Z plane. To structures that are similar to structures of the focus detection pixels 11 of Fig. 7(a) and to structures of the focus detection pixels 13 of Fig. 7(b), the same reference symbols are appended, and explanation thereof will be curtailed.

In Fig. 12(a), the filter 43C is a so-called white filter that transmits all of light in the red color wavelength region, light in the green color wavelength region, and light in the blue color wavelength region. And, for example, the focus detection pixel 11 comprises a discharge unit 44C that covers almost the entire area of the upper portion of its photoelectric conversion unit 41 (i.e. its portion toward the +Z axis direction). Due to the provision of this discharge unit 44C, a portion of the electric charge based upon the first ray bundle 651 and the second ray bundle 652 is discharged, irrespective of whether or not the focus detection pixel 11 needs it for performing phase difference detection. For example, the discharge unit 44C may be controlled so as to continue discharge of electric charge only when a focus detection signal for automatic focus adjustment (AF) is being generated by the focus detection pixel 11.

The signal Sig(11) obtained due to the focus detection pixel 11 that is provided with the discharge unit 44C may be derived according to the following Equation (10):

$$Sig(11) = S1(1\text{-}A) + S2(1\text{-}B) + S2'(1\text{-}B') \, ... \, (10)$$

Here, the coefficient of absorption by the discharge unit 44C for the unnecessary light that is not required for phase difference detection (i.e. the first ray bundle 651) is termed A, the coefficient of absorption by the discharge unit 44C for the light that is required for phase difference detection (i.e. the second ray bundle 652) is termed B, and the coefficient of absorption by the discharge unit 44C for the light reflected by the reflecting portion 42A is termed B'. It should be understood that A=B>B'.

According to the above Equation (10), the first term is zero when A=B. Directing attention to the second term, generally, the light absorptivity in the semiconductor layer 105 differs according to the wavelength. For example, in the case of employing a silicon substrate whose thickness is from 2 $\mu$m to 2.5 $\mu$m, the light absorptivity is around 60% for red color light (of wavelength about 600 nm), about 90% for green color light (of wavelength about 530 nm), and about 100% for blue color light (of wavelength about 450 nm). For this reason, the light that is transmitted through the photoelectric conversion unit 41 is principally red color light and green color light. Accordingly, it may be said that the signal S2' based upon the light, among the second ray bundle that has passed through the photoelectric conversion unit 41 and that has been reflected by the reflecting portion 42A to be again incident upon the photoelectric conversion unit 41, is due to red color light and to green color light. Thus, according to this third variant embodiment of the first embodiment, it is possible to eliminate the influence of blue color light from the signal S2' without employing any color filter.

The third term in Equation (10) above is based upon light of a similar wavelength to the signal Sig(12) derived according to Equation (3) above that was obtained due to the imaging pixel 12. In other words, since this is a signal that is obtained due to the first ray bundle 651 and the second ray bundle 652 being incident upon the photoelectric conversion unit 41, accordingly it may be said to be equivalent to a constant multiple of the signal Sig(12) from the imaging pixel 12. From the above, it is possible to obtain the difference diff2 between the signal Sig(12) and the signal Sig(11) by subtracting (1-A) times the signal Sig(12) due to the imaging pixel 12 from the signal Sig(11) of Equation (10) above due to the focus detection pixel 11.

In this manner, in the focus detection pixel 11, it is possible to eliminate the signal S1 based upon the light that is not required (i.e. the first ray bundle 651 that has passed through the first pupil region 61) from the signal Sig(11). Due to this, the accuracy of pupil splitting by the pupil-split structure (i.e. the reflecting portion 42A) of the focus detection pixel 11 is enhanced. As a result, an image sensor 22 is obtained with which the accuracy of pupil-split type phase difference detection is improved.

In a similar manner, in Fig. 12(b), the filter 43C is a so-called white filter that transmits all of light in the red color wavelength region, light in the green color wavelength region, and light in the blue color wavelength region. And, for example, the focus detection pixel 13 comprises a discharge unit 44C that covers almost the entire area of the upper portion of its photoelectric conversion unit 41 (i.e. its portion toward the +Z axis direction). Due to the provision of this discharge unit 44C, a portion of the electric charge based upon the first ray bundle 651 and the second ray bundle 652 is discharged, irrespective of whether or not the focus detection pixel 13 needs it for performing phase difference detection. For example, the discharge unit 44C may be controlled so as to continue discharge of electric charge only when a focus detection signal for automatic focus adjustment (AF) is being generated by the focus detection pixel 13.

The signal Sig(13) obtained due to the focus detection pixel 13 that is provided with this discharge unit 44C may be derived according to the following Equation (11):

$$Sig(13) = S2(1-A) + S1(1-B) + S1'(1-B') \dots (11)$$

Here, the coefficient of absorption by the discharge unit 44C for the unnecessary light that is not required for phase difference detection (i.e. the second ray bundle 652) is termed A, the coefficient of absorption by the discharge unit 44C for the light that is required for phase difference detection (i.e. the first ray bundle 651) is termed B, and the coefficient of absorption by the discharge unit 44C for the light reflected by the reflecting portion 42A is termed B'. It should be understood that A=B>B'.

According to the above Equation (11), the first term is zero when A=B. Directing attention to the second term, in the same way as in the case of the focus detection pixel 11, it may be said that the signal S1' based upon the light, among the first ray bundle that has passed through the photoelectric conversion unit 41 and that has been reflected by the reflecting portion 42B to be again incident upon the photoelectric conversion unit 41, is due to red color light and to green color light. Accordingly it is possible to eliminate the influence of blue color light from the signal S1' without employing any color filter.

The third term in Equation (11) above is the same as the third term in Equation (10) above. Due to this, it is possible to obtain the difference diff1 between the signal Sig(12) and the signal Sig(11) by subtracting (1-A) times the signal Sig(12) due to the imaging pixel 12 from the signal Sig(13) of Equation (11) above due to the focus detection pixel 13.

In this manner, in the focus detection pixel 13, it is possible to eliminate the signal S2 based upon the light that is not required (i.e. the first ray bundle 652 that has passed through the first pupil region 62) from the signal Sig(13). Due to this, the accuracy of pupil splitting by the pupil-split structure (i.e. the reflecting portion 42A) of the focus detection pixel 13 is enhanced. As a result, an image sensor 22 is obtained with which the accuracy of pupil-split type phase difference detection is improved.

Arrangement

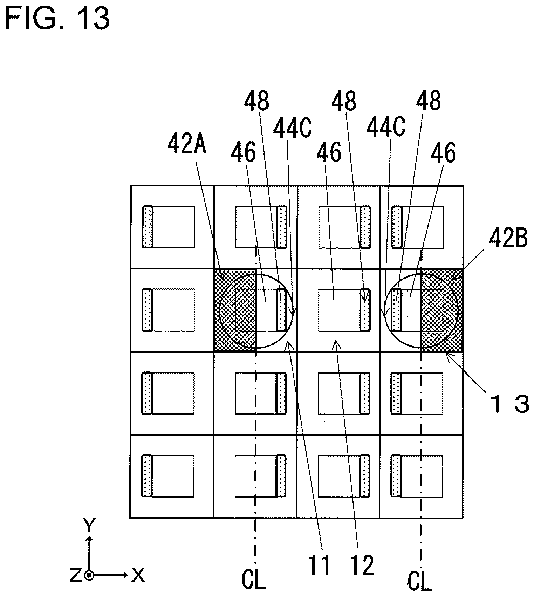

Fig. 13 is a plan view schematically showing the arrangement of focus detection pixels 11, 13 and an imaging pixel 12 sandwiched between two them. From the plurality of pixels arrayed within the region 22a (refer to Fig. 3) of the image sensor 22 that generates an image, a total of sixteen pixels arranged in a four row by four column array are extracted and illustrated in Fig. 13. In Fig. 13, each single pixel is shown as an outlined white square. As described above, the focus detection pixels 11, 13 are both disposed at positions for R pixels. It should be understood that it would also be acceptable for the focus detection pixels 11, 13 to be both disposed at positions for G pixels.

The gate electrodes 48 of the transfer transistors in the imaging pixel 12 and the focus detection pixels 11, 13 are, for example, shaped as rectangles that are longer in the column direction (i.e. in the Y axis direction). And the gate electrode 48 of the focus detection pixel 11 is disposed more toward the +X axis direction than the center line of the photoelectric conversion unit 41. In other words, in a plane that intersects the direction in which light is incident (i.e. the -Z axis direction) and that is parallel to the direction in which the focus detection pixels 11, 13 are arranged (i.e. the +X axis direction), the gate electrode 48 of the focus detection pixel 11 is provided more toward the direction of arrangement (i.e. the +X axis direction) than the center line of the photoelectric conversion unit 41.

It should be understood that, as described above, the n+ regions 46 formed in the pixels are parts of the photodiodes.

On the other hand, the gate electrode 48 of the focus detection pixel 13 is disposed more toward the -X axis direction than the center (the line CL) of the photoelectric conversion unit 41. In other words, in a plane that intersects the direction in which light is incident (i.e. the -Z axis direction) and that is parallel to the direction in which the focus detection pixels 11, 13 are arrayed (i.e. the +X axis direction), the gate electrode 48 of the focus detection pixel 13 is provided so as to be more toward the direction (i.e. the -X axis direction) opposite to the direction of arrangement (i.e. the +X axis direction) than the center line (the line CL) of the photoelectric conversion unit 41.

The reflecting portion 42A of the focus detection pixel 11 is provided at a position that corresponds to the left half of the pixel. Moreover, the reflecting portion 42B of the focus detection pixel 13 is provided at a position that corresponds to the right half of the pixel. In other words, in a plane that intersects the direction of light incidence (i.e. the -Z axis direction), the reflecting portion 42A of the focus detection pixel 11 is provided in a region more toward the direction opposite (i.e. the -X axis direction) to the direction of arrangement of the focus detection pixels 11, 13 (i.e. the +X axis direction) than the center of the photoelectric conversion unit 41 of the focus detection pixel 11 (i.e. than the line CL). And, in a similar manner, in a plane that intersects the direction of light incidence (i.e. the -Z axis direction), the reflecting portion 42B of the focus detection pixel 13 is provided in a region more toward the direction of arrangement (i.e. the +X axis direction) of the focus detection pixels 11, 13 than the center of the photoelectric conversion unit 41 of the focus detection pixel 13 (i.e. than the line CL).

In Fig. 13, the discharge units 44B of the focus detection pixels 11, 13 are illustrated as being in positions to cover almost the entire areas of their pixels. This means that, in the focus detection pixel 11 and the focus detection pixel 13, the discharge units 44C are provided at positions such that the first ray bundle 651 and the second ray bundle 652 can easily be absorbed, respectively.

Furthermore, in Fig. 13, the gate electrode 48 and the reflecting portion 42A of the focus detection pixel 11 and the gate electrode 48 and the reflecting portion 42B of the focus detection pixel 13 are arranged symmetrically left and right (i.e. symmetrically with respect to the imaging pixel 12 that is sandwiched between the focus detection pixels 11, 13). For example, the shapes, the areas, and the positions of the gate electrodes 48, and the shapes, the areas, and the positions and so on of the reflecting portion 42A and the reflecting portion 42B, are aligned with each another. Due to this, light incident upon the focus detection pixel 11 and upon the focus detection pixel 13 is reflected in a similar manner by their respective reflecting portion 42A and reflecting portion 42B, and is photoelectrically converted in a similar manner; and, due to this, the signal Sig(11) and the signal Sig(13) that are suitable for phase difference detection are outputted.

Yet further, in the plan view of Fig. 13, the gate electrodes 48 of the transfer transistors of the focus detection pixels 11, 13 are illustrated as being positioned on opposite sides to the reflecting portions 42A, 42B, in other words, as being positioned at positions where, in plan view, they do not overlap with the reflecting portions 42A, 42B. This means that, in the focus detection pixel 11, the gate electrode 48 is positioned away from the optical path along which light that has passed through the photoelectric conversion unit 41 is incident upon the reflecting portion 42A. Moreover it means that, in the focus detection pixel 13, the gate electrode 48 is positioned away from the optical path along which light that has passed through the photoelectric conversion unit 41 is incident upon the reflecting portion 42B. Due to this, it is possible to obtain a signal Sig(11) and a signal Sig(13) in which the influence of reflection or absorption by the gate electrodes 48 is suppressed, which is different from the case in which the gate electrodes are present upon the optical paths.

According to the third variant embodiment of the first embodiment described above, the following operation and beneficial effect is obtained.

The reflecting portion 42A (42B) of the focus detection pixel 11 (13) of the image sensor 22 of Fig. 12 is, for example, disposed at a position in which it reflects one of the ray bundles, among the first and second ray bundles 651, 652 that have passed through the first and second pupil regions 61, 62 of the exit pupil 60 of the imaging optical system 31 (refer to Fig. 5); the photoelectric conversion unit 41 photoelectrically converts the first and second ray bundles 651, 652 and the ray bundle reflected by the reflecting portion 42A (42B); and the discharge unit 44C discharges a portion of the electric charge generated on the basis of the first and second ray bundles 651, 652.

For example, let the absorption coefficient by the discharge unit 44C for the light that is not required by the focus detection pixel 11 for phase difference detection (i.e. for the first ray bundle 651) be termed A, and the absorption coefficient by the discharge unit 44C for the light that is required by the focus detection pixel 11 for phase difference detection (i.e. for the second ray bundle 652) be termed B: then the first term of Equation (10) above can be zero if A=B.

Moreover if, for example, a silicon substrate having a thickness of about 2 $\mu$m to 2.5 $\mu$m is employed, then the light that passes through the photoelectric conversion unit 41 may be said to be principally red color light and green color light. Due to this, the signal S2' based upon the light, among the second ray bundle that has passed through the photoelectric conversion unit 41, that is reflected by the reflecting portion 42A and is again incident upon the photoelectric conversion unit 41 may be said to be entirely based upon red color light and green color light. In other words, according to this third variant embodiment of the first embodiment, it is possible to eliminate the influence of blue color light from the signal S2' in the second term of Equation (10) above without employing any color filter.

It would also be acceptable to employ the electric charges discharged from the discharge units 44 (44A), 44B, and 44C explained in connection with the embodiments and variant embodiments described above for the generation processing, the interpolation processing, and the correction processing of the image data. For example, an image related to the photographic subject may be generated by employing a signal based upon the discharged electric charge. Moreover, interpolation of the image signal may be performed by employing a signal based upon the discharged electric charge. Even further, the focus detection signal or the image signal may be corrected by employing a signal based upon the discharged electric charge.

Embodiment Two

As explained in connection with the first embodiment, signals based upon light that is not necessary for phase difference detection are included in the signal Sig(11) obtained due to the focus detection pixel 11 of Equation (2) above and in the signal Sig(13) obtained due to the focus detection pixel 13 of Equation (1) above. In the first embodiment, as one example of eliminating signal components that are not required for phase difference detection, a technique was disclosed by way of example in which the focus detection unit 21a, along with obtaining the difference diff2 between the signal Sig(12) from the imaging pixel 12 and the signal Sig(11) from the focus detection pixel 11, also obtained the difference diff1 between the signal Sig(12) from the imaging pixel 12 and the signal Sig(13) from the focus detection pixel 13.

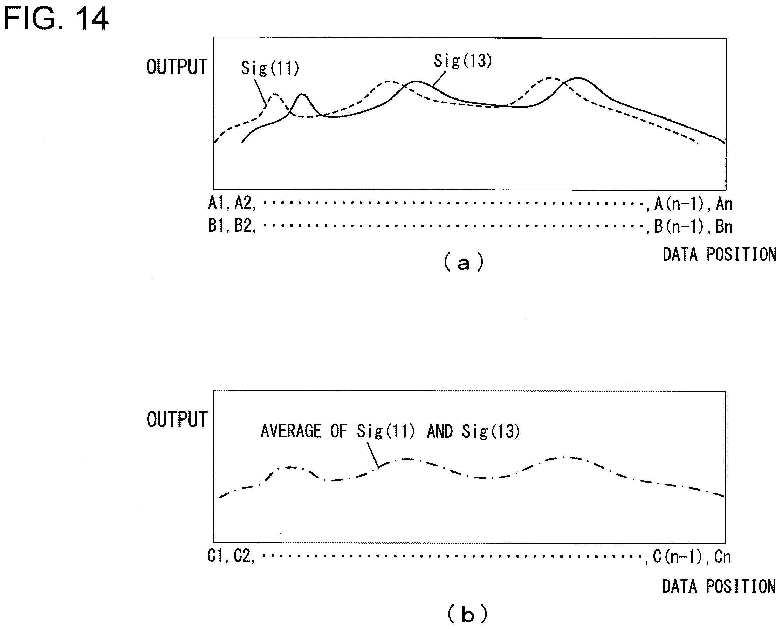

Now, in a second embodiment, another example of eliminating signal components that are not required for phase difference detection from the signal Sig(11) obtained due to the focus detection pixel 11 and from the signal Sig(13) obtained due to the focus detection pixel 13 will be explained with reference to Fig. 14.

Fig. 14(a) is a figure showing examples of an "a" group of signals due to the focus detection pixels 11 and a "b" group of signals due to the focus detection pixels 13. In Fig. 14(a), signals Sig(11) respectively outputted from a plurality (for example, n) of focus detection pixels 11 (A1, A2, ... An) included in the plurality of units described above are shown by a broken line as an "a" group of signals (A1, A2, ... An). Furthermore, signals Sig(13) respectively outputted from a plurality (for example, n) of focus detection pixels 13 (B1, B2, ... Bn) included in the plurality of units described above are shown by a broken line as a "b" group of signals (B1, B2, ... Bn).

And Fig. 14(b) is a figure showing an example of signals obtained by averaging the "a" group of signals and the "b" group of signals described above. In Fig. 14(b), the average of the signals Sig(11) due to the focus detection pixels 11 and the signals Sig(13) due to the focus detection pixels 13 included in the plurality of units described above is shown by a single dotted chain line as signals (C1, C2, ... Cn).

By performing filtering processing upon the signals (C1, C2, ... Cn) obtained by averaging the "a" group of signals described above and the "b" group of signals described above, the focus detection unit 21a obtains signals (FC1, FC2, ... FCn) with components of higher frequency than a predetermined cutoff frequency being eliminated from the signals (C1, C2, ... Cn). These signals (FC1, FC2, ... FCn) are low frequency component signals that do not include fine variations of contrast due to the pattern upon the photographic subject.

And the focus detection unit 21a obtains signals (FA1, FA2, ... FAn) by subtracting the signals (FC1, FC2, ... FCn) described above from the signals Sig(11) from the focus detection pixels 11. Moreover, the focus detection unit 21a obtains signals (FB1, FB2, ... FBn) by subtracting the signals (FC1, FC2, ... FCn) described above from the signals Sig(13) from the focus detection pixels 13. The signals (FA1, FA2, ... FAn) are signals consisting of the high frequency component in the "a" group of signals (A1, A2, ... An), and includes fine variations of contrast due to the pattern upon the photographic subject. In a similar manner, the signals (FB1, FB2, ... FBn) are signals consisting of the high frequency component in the "b" group of signals (B1, B2, ... Bn), and includes fine variations of contrast due to the pattern upon the photographic subject.

The focus detection unit 21a obtains the amount of image deviation between the image due to the first ray bundle that has passed through the first pupil region 61 (refer to Fig. 5) and the image due to the second ray bundle that has passed through the second pupil region 62 (refer to Fig. 5) on the basis of the signals (FA1, FA2, ... FAn) and the signals (FB1, FB2, ... FBn) described above, and calculates the amount of defocusing on the basis of this amount of image deviation.

Since, in general, the phase difference information required for phase difference detection is based upon the pattern upon the photographic subject, therefore it is possible to perform detection of fine contrast phase differences according to the pattern upon the photographic subject by employing the signals (FA1, FA2, ... FAn) and the signals (FB1, FB2, ... FBn) that are in a frequency band higher than a frequency determined in advance. By doing this, it is possible to enhance the accuracy of detection of the amount of image deviation.

It should be understood that the focus detection unit 21a may perform the processing described above upon the signal Sig(11) due to the focus detection pixel 11 in Equation (4) described above, or in Equation (6) described above, or in Equation (8) described above. Furthermore, the focus detection unit 21a may perform the processing described above upon the signal Sig(13) due to the focus detection pixel 13 in Equation (5) described above, or in Equation (7) described above, or in Equation (9) described above.

According to the second embodiment described above, the following operation and beneficial effect is obtained.

The focus adjustment device mounted to the camera 1 provides similar operations and beneficial effects to those provided by the focus adjustment device of the first embodiment. Furthermore, the body control unit 21 of the focus adjustment device subtracts the low frequency component of the average of the plurality of signals Sig(11) (Sig(13)) from the plurality of signals Sig(11) (Sig(13)). Thus, it is possible to extract the high frequency component signal including fine variations of contrast due to the pattern upon the photographic subject from the plurality of signals Sig(11) (Sig(13)) by simple processing such as averaging processing and subtraction processing.

Variant Embodiment 1 of Embodiment Two

Another example will now be explained in which, according to a first variant embodiment of the second embodiment, components that are not required for phase difference detection are eliminated from the signals Sig(11) obtained due to the focus detection pixels 11 and the signals Sig(13) obtained due to the focus detection pixels 13.

By performing filter processing upon the "a" group of signals Sig(11) due to the focus detection pixels 11, the focus detection unit 21a obtains signals (FA1, FA2, ... FAn) in which a low frequency component of frequency lower than a cutoff frequency determined in advance has been eliminated from the signals Sig(11). This signals (FA1, FA2, ... FAn) are high frequency component signals in the signal (A1, A2, ... An), and includes fine variations of contrast due to the pattern upon the photographic subject.

Furthermore, by performing filter processing upon the "b" group of signals Sig(13) due to the focus detection pixels 13, the focus detection unit 21a obtains signals (FB1, FB2, ... FBn) in which a low frequency component of frequency lower than a cutoff frequency determined in advance has been eliminated from the signals Sig(13). Thes signals (FB1, FB2, ... FBn) are high frequency component signals in the signals (B1, B2, ... Bn), and includes fine variations of contrast due to the pattern upon the photographic subject.

And, on the basis of the signals (FA1, FA2, ... FAn) described above and the signals (FBI, FB2, ... FBn) described above, the focus detection unit 21a obtains the amount of image deviation between the image due to the first ray bundle that has passed through the first pupil region 61 (refer to Fig. 5) and the image due to the second ray bundle that has passed through the second pupil region 62 (refer to Fig. 5), and calculates an amount of defocusing on the basis of this amount of image deviation.

Moreover, in this first variant embodiment of the second embodiment, by employing the signals (FA1, FA2, ... FAn) and the signals (FB1, FB2, ... FBn) of higher frequency bands than the frequency determined in advance, it is possible to detect the amount of image deviation with good accuracy on the basis of the fine contrast phase differences in the pattern upon the photographic subject. Due to this, it is possible to enhance the accuracy of detection in pupil-split type phase difference detection.

It should be understood that the focus detection unit 21a may perform the processing described above for any of the signals Sig(11) due to the focus detection pixel 11 in Equation (4) above, or Equation (6) above, or Equation (8) above. Moreover, the focus detection unit 21a may perform the processing described above for any of the signals Sig(13) due to the focus detection pixel 13 in Equation (5) above, or Equation (7) above, or Equation (9) above.

According to the first variant embodiment of the second embodiment described above, the following operation and beneficial effect is obtained.

The body control unit 21 of the focus adjustment device extracts the high frequency component of the plurality of signals Sig(11) (Sig(13)) from the plurality of signals Sig(11) (Sig(13)). By simple processing such as low band cutoff filter processing, it is possible to extract the high frequency component signal that includes fine variations of contrast due to the pattern upon the photographic subject from the plurality of signals Sig(11) (Sig(13)).

Directions of Arrangement of the Focus Detection Pixels

In the embodiments and the variant embodiments described above, it would also be acceptable to vary the directions in which the focus detection pixels are arranged, in the following ways.

In general, when performing focus detection upon a pattern on a photographic subject that extends in the vertical direction, it is preferred for the focus detection pixels to be arranged along the row direction (i.e. the X axis direction), in other words along the horizontal direction. Moreover, when performing focus detection upon a pattern on a photographic subject that extends in the horizontal direction, it is preferred for the focus detection pixels to be arranged along the column direction (i.e. the Y axis direction), in other words along the vertical direction. Accordingly, in order to perform focus detection irrespective of the direction of the pattern of the photographic subject, it is desirable to have both focus detection pixels that are arranged along the horizontal direction and also focus detection pixels that are arranged along the vertical direction.

Accordingly, for example, in the focusing areas 101-1 through 101-3 of Fig. 2, the focus detection pixels 11, 13 are arranged along the horizontal direction. Moreover, for example, in the focusing areas 101-4 through 101-11, the focus detection pixels 11, 13 are arranged along the vertical direction. By providing a structure of this type, it is possible to arrange the focus detection pixels of the image sensor 22 both along the horizontal direction and along the vertical direction.

It should be understood that, if the focus detection pixels 11, 13 are arranged along the vertical direction, then the reflecting portions 42A, 42B of the focus detection pixels 11, 13 are arranged so as, respectively, to correspond to regions almost at the lower halves and to regions almost at the upper halves of their corresponding photoelectric conversion units 41 (i.e., respectively, toward the -Y axis sides and towards the +Y axis sides thereof). In the XY plane, at least a portion of the reflecting portion 42A of the focus detection pixel 11 is, for example, provided in a region that, among regions divided by a line orthogonal to the line CL in Fig. 4 etc. and parallel to the X axis, is toward the -Y axis direction. Similarly, in the XY plane, at least a portion of the reflecting portion 42B of the focus detection pixel 13 is, for example, provided in a region that, among regions divided by a line orthogonal to the line CL in Fig. 4 etc. and parallel to the X axis, is toward the +Y axis direction.

By arranging the focus detection pixels both along the horizontal direction and also along the vertical direction in this manner, it becomes possible to perform focus detection irrespective of the direction of the pattern upon the photographic subject.

It should be understood that, in the focusing areas 101-1 through 101-11 of Fig. 2, it would also be acceptable to arrange the focus detection pixels 11, 13 both along the horizontal direction and also along the vertical direction. By providing such an arrangement, it would become possible to perform focus detection with any of the focusing areas 101-1 through 101-11, irrespective of the direction of the pattern upon the photographic subject.

While various embodiments and variant embodiments have been explained above, the present invention is not to be considered as being limited to the details thereof. Other variations that are considered to come within the range of the technical concept of the present invention are also included within the scope of the present invention.

The content of the disclosure of the following application, upon which priority is claimed, is herein incorporated by reference.

Japanese Patent Application No. 2017-63678 (filed on March 28, 2017).

REFERENCE SIGNS LIST

1: camera
2: camera body
3: interchangeable lens
11, 13: focus detection pixels
12: imaging pixel
21: body control unit
21a: focus detection unit
22: image sensor
31: imaging optical system
40: micro lens
41: photoelectric conversion unit
42A, 42B: reflecting portions
43: color filter
43C: filter
44, 44A, 44B, 44C: discharge units
60: exit pupil
61: first pupil region
62: second pupil region
401, 401S, 402: pixel rows
CL: line passing through center of pixel (for example, through center of photoelectric conversion unit)

**Claims**

1. An image sensor, comprising:

a photoelectric conversion unit that photoelectrically converts incident light and generates electric charge;
a reflecting portion that reflects a portion of light passing through the photoelectric conversion unit toward the photoelectric conversion unit;
a first output unit that outputs electric charge generated due to photoelectric conversion by the photoelectric conversion unit of light reflected by the reflecting portion; and

a second output unit that outputs electric charge generated due to photoelectric conversion by the photoelectric conversion unit of light other than the light reflected by the reflecting portion.

2. The image sensor according to claim 1, wherein:
among the electric charge generated by the photoelectric conversion unit, the first output unit outputs electric charge generated by a side of the photoelectric conversion unit opposite to a side upon which light is incident with reference to a center of the photoelectric conversion unit.

3. The image sensor according to claim 1 or claim 2, wherein:
among the electric charge generated by the photoelectric conversion unit, the second output unit outputs electric charge generated by a side of the photoelectric conversion unit toward a side upon which light is incident with reference to a center of the photoelectric conversion unit.

4. The image sensor according to any one of claims 1 through 3, wherein:
among the electric charge generated by the photoelectric conversion unit, the first output unit outputs electric charge generated by a side of the photoelectric conversion unit upon which the reflecting portion is provided with reference to a center of the photoelectric conversion unit.

5. The image sensor according to any one of claims 1 through 4, wherein:
among the electric charge generated by the photoelectric conversion unit, the second output unit outputs electric charge generated by a side of the photoelectric conversion unit upon which the reflecting portion is not provided with reference to a center of the photoelectric conversion unit.

6. The image sensor according to any one of claims 1 through 5, wherein:
the second output unit is a discharge unit that discharges electric charge, among the electric charge generated by the photoelectric conversion unit, generated by photoelectric conversion of light other than light reflected by the reflecting portion.

7. The image sensor according to any one of claims 1 through 6, wherein:
the second output unit is a discharge unit that discharges unnecessary electric charge among the electric charge generated by the photoelectric conversion unit.

8. The image sensor according to any one of claims 1 through 7, further comprising:
a first pixel and a second pixel each of which comprises the photoelectric conversion unit and the reflecting portion, wherein:

the first pixel and the second pixel are arranged along a first direction;
in a plane that intersects a direction in which light is incident, the reflecting portion of the first pixel is provided in at least a part of a region that is more toward a direction opposite to the first direction than a center of the photoelectric conversion unit; and
in a plane that intersects the direction in which light is incident, the reflecting portion of the second pixel is provided in at least a part of a region that is more toward the first direction than the center of the photoelectric conversion unit.

9. The image sensor according to claim 8, wherein:

each of the first pixel and the second pixel has the first output unit;
the first output unit of the first pixel outputs electric charge generated by the photoelectric conversion unit due to light incident from the first direction; and
the first output unit of the second pixel outputs electric charge generated by the photoelectric conversion unit due to light incident from the direction opposite to the first direction.

10. The image sensor according to claim 8 or claim 9, further comprising:
a third pixel comprising the photoelectric conversion unit, wherein:

each of the first pixel and the second pixel has a first filter having a first spectral characteristic; and
the third pixel has a second filter having a second spectral characteristic, whose transmittance is higher for light having a shorter wavelength than that of the first spectral characteristic.

**11.** An imaging device, comprising:

an image sensor according to any one of claims 1 through 10; and
a control unit that controls a position of a focusing lens of an optical system so as to focus an image due to the optical system upon the image sensor, based upon a signal based upon electric charge outputted from the first output unit of the image sensor that captures an image due to the optical system.

**12.** An imaging device, comprising:

an image sensor according to any one of claims 8 through 10; and
a control unit that controls a position of a focusing lens of an optical system so as to focus an image due to the optical system upon the image sensor, based upon a signal based upon electric charge outputted from the first output unit of the first pixel and electric charge outputted from the first output unit of the second pixel of the image sensor that captures an image due to the optical system.

**13.** An imaging device according to claim 11 or claim 12, wherein:
the control unit controls the position of the focusing lens by extracting a high frequency component from at least one of a signal based upon electric charge outputted from the first output unit of the image sensor, and a signal based upon electric charge outputted from the second output unit of the image sensor.

**14.** An imaging device according to any one of claims 11 through 13, wherein:
the control unit controls the position of the focusing lens by subtracting an average low frequency component from at least one of a signal based upon electric charge outputted from the first output unit of the image sensor, and a signal based upon electric charge outputted from the second output unit of the image sensor.

# FIG. 1

# FIG. 2

EP 3 606 044 A1

## FIG. 3

# FIG. 4

(a)

(b)

(c)

# FIG. 5

FIG. 6

(b)

# FIG. 7

(a)

(b)

FIG. 8

# FIG. 9

（a）

（b）

## FIG. 10

# FIG. 11

(a)

(b)

# FIG. 12

(a)

(b)

# FIG. 13

FIG. 14

OUTPUT

Sig(11)          Sig(13)

A1, A2, · · · · · · · · · · · · · · · · · · · · · · · · · · · · · · · , A(n−1), An
B1, B2, · · · · · · · · · · · · · · · · · · · · · · · · · · · · · · · , B(n−1), Bn

DATA POSITION

（a）

OUTPUT

AVERAGE OF Sig(11) AND Sig(13)

C1, C2, · · · · · · · · · · · · · · · · · · · · · · · · · · · · · · · , C(n−1), Cn

DATA POSITION

（b）

EP 3 606 044 A1

## INTERNATIONAL SEARCH REPORT

| International application No. |
| --- |
| PCT/JP2018/012996 |

**A. CLASSIFICATION OF SUBJECT MATTER**
Int. Cl. H04N5/369(2011.01)i, G02B7/34(2006.01)i, G03B13/36(2006.01)i, H04N5/232(2006.01)i

According to International Patent Classification (IPC) or to both national classification and IPC

**B. FIELDS SEARCHED**

Minimum documentation searched (classification system followed by classification symbols)
Int. Cl. H04N5/369, G02B7/34, G03B13/36, H04N5/232

Documentation searched other than minimum documentation to the extent that such documents are included in the fields searched
Published examined utility model applications of Japan    1922-1996
Published unexamined utility model applications of Japan  1971-2018
Registered utility model specifications of Japan          1996-2018
Published registered utility model applications of Japan  1994-2018

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | JP 2016-127043 A (SONY CORP.) 11 July 2016, | 1-5 |
| Y | paragraphs [0074]-[0214] (Family: none) | 6-14 |
| Y | JP 2011-60815 A (NIKON CORP.) 24 March 2011, paragraph [0031], fig. 4, 6 (Family: none) | 6-14 |
| Y | JP 2009-175528 A (NIKON CORP.) 06 August 2009, paragraphs [0124], [0125] (Family: none) | 11-14 |
| A | WO 2016/063727 A1 (SONY CORP.) 28 April 2016, & US 2017/0229503 A1 | 1-14 |

☐ Further documents are listed in the continuation of Box C.　　☐ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| 04.06.2018 | 12.06.2018 |

| Name and mailing address of the ISA/ Japan Patent Office 3-4-3, Kasumigaseki, Chiyoda-ku, Tokyo 100-8915, Japan | Authorized officer |
| --- | --- |
|  | Telephone No. |

Form PCT/ISA/210 (second sheet) (January 2015)

# REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2016127043 A
- JP 2017063678 A